# EUROPEAN PATENT SPECIFICATION

(11) **EP 3 886 171 B1**
(45) Date of publication and mention of the grant of the patent: **26.08.2026**
(21) Application number: 20195262.9
(22) Date of filing: 09.09.2020
(51) Int. Cl.: H10F 39/12, H10F 39/00

(54) **LIGHT DETECTOR, LIGHT DETECTION SYSTEM, LIDAR DEVICE, AND VEHICLE**
LICHTDETEKTOR, LICHTDETEKTIONSSYSTEM, LIDAR-VORRICHTUNG UND FAHRZEUG
DÉTECTEUR DE LUMIÈRE, SYSTÈME DE DÉTECTION DE LUMIÈRE, DISPOSITIF LIDAR ET VÉHICULE

(30) Priority: 23.03.2020 JP 2020050754
(43) Date of publication of application: 29.09.2021
(73) Proprietor: KABUSHIKI KAISHA TOSHIBA, Minato-ku Tokyo 105-0023 (JP)
(72) Inventor: Fujiwara, Ikuo, Tokyo, 105-0023 (JP); Kwon, Honam, Tokyo, 105-0023 (JP); Sasaki, Keita, Tokyo, 105-0023 (JP); Suzuki, Kazuhiro, Tokyo, 105-0023 (JP); Atsuta, Masaki, Tokyo, 105-0023 (JP); Shimizu, Mariko, Tokyo, 105-0023 (JP); Okamoto, Kazuaki, Tokyo, 105-0023 (JP)
(74) Representative: Hoffmann Eitle

(56) References cited:
- EP-A1- 1 840 967
- US-A1- 2009 184 317
- US-A1- 2009 184 384
- US-A1- 2017 301 716

## Description

### FIELD

Embodiments described herein relate generally to a light detector, a light detection system, a lidar device, and a vehicle.

### BACKGROUND

A light detector detects light incident on a semiconductor region. It is desirable to increase the sensitivity of the light detector.
US 2009/184 317 A1 describes an array of Geiger-mode avalanche photodiodes, wherein each photodiode is formed by a body of semiconductor material, having a first conductivity type, housing a first cathode region, of the second conductivity type, and facing a surface of the body, an anode region, having the first conductivity type and a higher doping level than the body, extending inside the body, and facing the surface laterally to the first cathode region and at a distance therefrom, and an insulation region extending through the body and insulating an active area from the rest of the body, the active area housing the first cathode region and the anode region. The insulation region is formed by a mirror region of metal material, a channel-stopper region having the second conductivity type, surrounding the mirror region, and a coating region, of dielectric material, arranged between the mirror region and the channel-stopper region.
US 2009/184 384 A1 describes an array of Geiger-mode avalanche photodiodes, wherein each photodiode is formed by a body of semiconductor material, having a first conductivity type and housing an anode region, of a second conductivity type, facing a top surface of the body, a cathode-contact region, having the first conductivity type and a higher doping level than the body, facing a bottom surface of the body, an insulation region extending through the body and insulating an active area from the rest of the body, the active area housing the anode region and the cathode-contact region. The insulation region is formed by a first mirror region of polycrystalline silicon, a second mirror region of metal material, and a channel-stopper region of dielectric material, surrounding the first and second mirror regions.
EP 1 840 967 A1 describes a photodiode array which can secure a sufficient aperture ratio with respect to light to be detected while restraining crosstalk between photodetecting channels even during operation in Geiger mode. In a photodiode array, resistors and wirings to be electrically connected to avalanche multipliers, respectively, are collectively formed on the upper surface side of a semiconductor substrate. Therefore, by setting the lower surface side of the semiconductor substrate as a lightincident side, a sufficient aperture ratio can be secured while restraining crosstalk between photodetecting channels by separators. Furthermore, on the lower surface side of the semiconductor substrate, accumulation layers are formed, so that high quantum efficiency in each photodetecting channel is secured and the effective aperture ratio is improved. The accumulation layers lower the contact resistance between the semiconductor substrate and the transparent electrode layer and make it possible to form a satisfactory contact.
US 2017/301 716 A1 describes an optical sensor that reduces noise from sources of light other than the LIDAR transmitter by changing the active area of the sensor of a LIDAR receiver. The optical sensor may include a two dimensional array of single photon avalanche devices (SPADs) with rowselect and column-select transistors, where rows and columns are selected based on a predicted spot size and angle of reflected laser light detected at the LIDAR receiver.
The underlying problem is solved by the subject matter of the independent claim. Examples and technical descriptions of apparatuses, products and/or methods in the description and/or drawings which are not covered by the claims are presented not as embodiments of the invention but as background art or examples useful for understanding the invention.

### BRIEF DESCRIPTION OF THE DRAWINGS

FIG. 1 is a schematic plan view illustrating a light detector according to a first embodiment;
FIG. 2 is an enlarged plan view of portion II of FIG. 1;
FIG. 3 is an A1-A2 cross-sectional view of FIG. 2;
FIG. 4 is an enlarged view of a portion of FIG. 3;
FIGS. 5A and 5B are schematic views illustrating manufacturing processes of the light detector according to the first embodiment;
FIGS. 6A and 6B are schematic views illustrating manufacturing processes of the light detector according to the first embodiment;
FIGS. 7A and 7B are schematic views illustrating manufacturing processes of the light detector according to the first embodiment;
FIGS. 8A and 8B are schematic views illustrating manufacturing processes of the light detector according to the first embodiment;
FIGS. 9A and 9B are schematic views illustrating manufacturing processes of the light detector according to the first embodiment;
FIGS. 10A and 10B are schematic views illustrating manufacturing processes of the light detector according to the first embodiment;
FIGS. 11A and 11B are schematic views illustrating manufacturing processes of the light detector according to the first embodiment;
FIGS. 12A and 12B are schematic views illustrating manufacturing processes of the light detector according to the first embodiment;
FIGS. 13A and 13B are schematic views illustrating manufacturing processes of the light detector according to the first embodiment;
FIGS. 14A and 14B are schematic views illustrating manufacturing processes of the light detector according to the first embodiment;
FIGS. 15A and 15B are schematic views illustrating manufacturing processes of the light detector according to the first embodiment;
FIGS. 16A and 16B are schematic views illustrating manufacturing processes of the light detector according to the first embodiment;
FIGS. 17A and 17B are schematic views illustrating manufacturing processes of the light detector according to the first embodiment;
FIGS. 18A and 18B are schematic views illustrating manufacturing processes of the light detector according to the first embodiment;
FIG. 19 is a schematic view illustrating manufacturing processes of the light detector according to the first embodiment;
FIG. 20 is a schematic cross-sectional view illustrating a light detector according to a reference example not forming part of the claimed invention;
FIG. 21 is a schematic cross-sectional view illustrating a portion of the light detector according to the first embodiment;
FIG. 22 is a schematic plan view illustrating a portion of the light detector according to the first embodiment;
FIG. 23 is a schematic plan view illustrating a portion of the light detector according to the first embodiment;
FIG. 24 is a schematic plan view illustrating a portion of a light detector according to a reference example not forming part of the claimed invention;
FIG. 25 is a schematic plan view illustrating a light detector according to a modification of the first embodiment;
FIG. 26 is an A1-A2 cross-sectional view of FIG. 25;
FIG. 27 is a schematic plan view illustrating a portion of a light detector according to a second embodiment;
FIG. 28 is a schematic plan view illustrating a portion of a light detector according to a second embodiment;
FIG. 29 is a schematic plan view illustrating a portion of a light detector according to a second embodiment;
FIG. 30 is an A1-A2 cross-sectional view of FIGS. 27 to 29;
FIGS. 31A and 31B are schematic views illustrating manufacturing processes of the light detector according to the second embodiment;
FIGS. 32A and 32B are schematic views illustrating manufacturing processes of the light detector according to the second embodiment;
FIGS. 33A and 33B are schematic views illustrating manufacturing processes of the light detector according to the second embodiment;
FIGS. 34A and 34B are schematic views illustrating manufacturing processes of the light detector according to the second embodiment;
FIGS. 35A and 35B are schematic views illustrating manufacturing processes of the light detector according to the second embodiment;
FIG. 36 is a schematic plan view illustrating a portion of a light detector according to a reference example;
FIG. 37 is a schematic cross-sectional view illustrating a portion of the light detector according to the second embodiment;
FIG. 38 is a schematic view illustrating manufacturing processes of the light detector according to the second embodiment;
FIG. 39 is a schematic plan view illustrating a portion of a light detector according to a third embodiment;
FIG. 40 is a schematic plan view illustrating a portion of the light detector according to the third embodiment;
FIG. 41 is an A1-A2 cross-sectional view of FIGS. 39 and 40;
FIG. 42 is a schematic cross-sectional view illustrating a portion of a light detector according to a modification of the third embodiment;
FIG. 43 is a graph illustrating characteristics of the light detector according to the embodiment;
FIG. 44 is a graph illustrating characteristics of the light detector according to the embodiment;
FIG. 45 is a schematic cross-sectional view illustrating a portion of the light detector according to the second embodiment;
FIG. 46 is a graph illustrating a characteristic of the light detector according to the second embodiment;
FIG. 47 is a schematic view illustrating a lidar (Laser Imaging Detection and Ranging (LIDAR)) device according to a fourth embodiment;
FIG. 48 is a drawing for describing the detection of the detection object of the lidar device; and
FIG. 49 is a schematic top view of a vehicle including the lidar device according to the fourth embodiment.

### DETAILED DESCRIPTION

According to one embodiment, a light detector includes an element, and a structure body. The element includes a first semiconductor region of a first conductivity type, a second semiconductor region of the first conductivity type, and a third semiconductor region of a second conductivity type. The second semiconductor region is provided on the first semiconductor region, and has an impurity concentration of the first conductivity type less than in the first semiconductor region. The third semiconductor region is provided on the second semiconductor region. The structure body is provided around the element in a first plane perpendicular to a first direction. The first direction is from the first semiconductor region toward the second semiconductor region. The structure body includes a first insulating portion, a metal-including portion, and a second insulating portion. The metal-including portion is provided above the first insulating portion. A position in the first direction of at least a portion of the metal-including portion is same as a position in the first direction of the third semiconductor region. The second insulating portion is provided above the first insulating portion, and is positioned between the metal-including portion and the element in the first plane. A thickness in the first direction of the first insulating portion is greater than a thickness of the second insulating portion in the first plane between the element and the metal-including portion.

Various embodiments are described below with reference to the accompanying drawings.

The drawings are schematic and conceptual; and the relationships between the thickness and width of portions, the proportions of sizes among portions, etc., are not necessarily the same as the actual values. The dimensions and proportions may be illustrated differently among drawings, even for identical portions.

In the specification and drawings, components similar to those described previously in an antecedent drawing are marked with like reference numerals, and a detailed description is omitted as appropriate.

### First embodiment

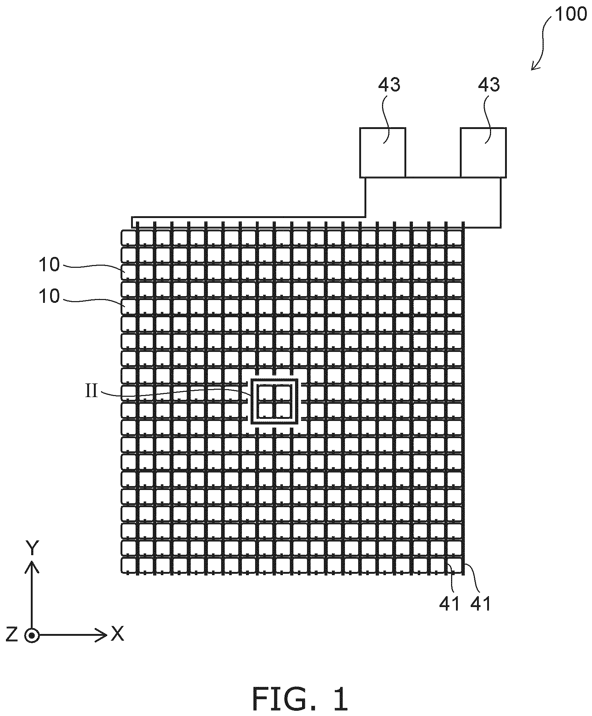

FIG. 1 is a schematic plan view illustrating a light detector according to a first embodiment.

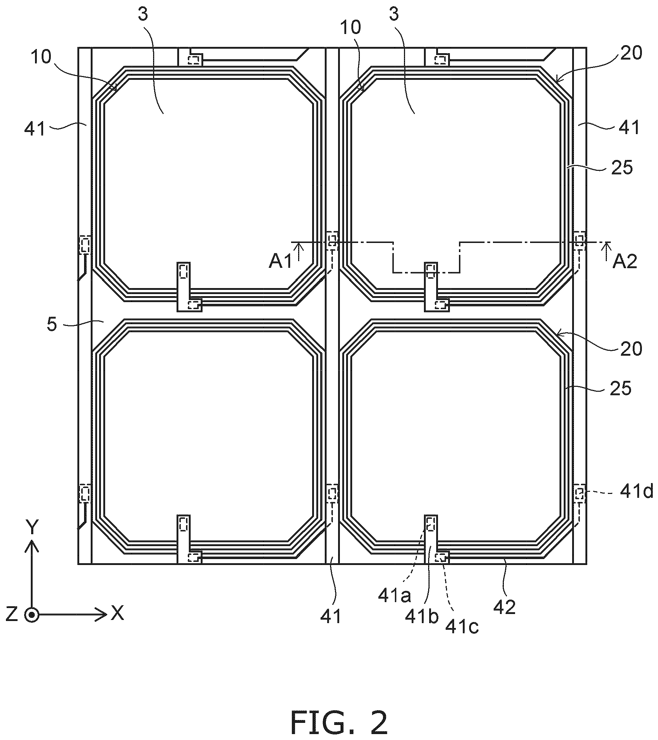

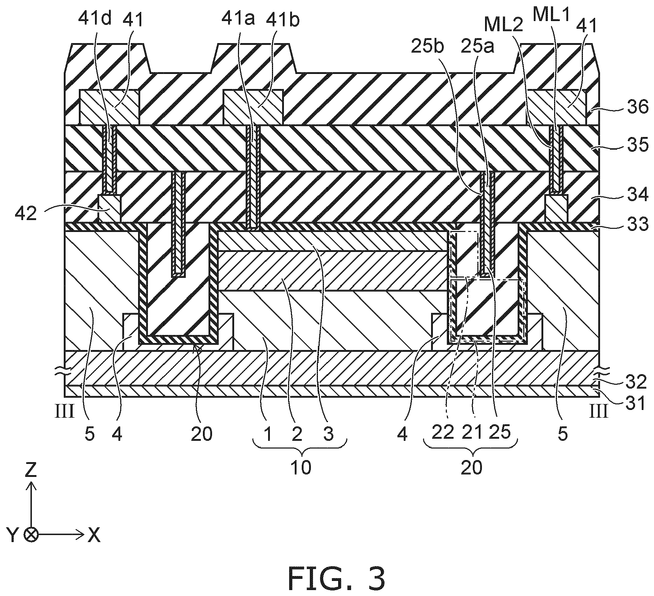

FIG. 2 is an enlarged plan view of portion II of FIG. 1. FIG. 3 is an A1-A2 cross-sectional view of FIG. 2.

As shown in FIGS. 1 to 3, the light detector 100 according to the first embodiment includes an element 10, a structure body 20, an electrode 31, a conductive layer 32, insulating layers 33 to 36, an interconnect 41, a quenching part 42, and a pad 43.

As illustrated in FIG. 3, the element 10 includes a first semiconductor region 1 of a first conductivity type, a second semiconductor region 2 of the first conductivity type, and a third semiconductor region 3 of a second conductivity type. The first conductivity type is one of a p-type or an n-type. The second conductivity type is the other of the p-type or the n-type. In the description hereinbelow, the first conductivity type is the p-type, and the second conductivity type is the n-type.

Here, the direction from the first semiconductor region 1 toward the second semiconductor region 2 is taken as a Z-direction (a first direction). Two mutually-orthogonal directions perpendicular to the Z-direction are taken as an X-direction (a second direction) and a Y-direction (a third direction). In the description, the direction from the first semiconductor region 1 toward the second semiconductor region 2 is called "up", and the reverse direction is called "down". These directions are based on the relative positional relationship between the first semiconductor region 1 and the second semiconductor region 2 and are independent of the direction of gravity.

The second semiconductor region 2 is provided on the first semiconductor region 1. The p-type impurity concentration in the second semiconductor region 2 is greater than the p-type impurity concentration in the first semiconductor region 1. The third semiconductor region 3 is provided on the second semiconductor region 2 and contacts the second semiconductor region 2. A p-n junction is formed between the second semiconductor region 2 and the third semiconductor region 3. For example, the p-n junction surface is parallel to the X-direction and the Y-direction.

The structure body 20 is provided around the element 10 in the X-Y plane (a first plane) perpendicular to the Z-direction. The structure body 20 includes a first insulating portion 21, a second insulating portion 22, and a metal-including portion 25.

The second insulating portion 22 and the metal-including portion 25 are provided higher than the first insulating portion 21. In the example shown in FIG. 3, the second insulating portion 22 and the metal-including portion 25 are positioned on the first insulating portion 21. The second insulating portion 22 is positioned between the element 10 and the metal-including portion 25.

At least a portion of the metal-including portion 25 is provided at the same height as the third semiconductor region 3. In other words, the position in the Z-direction of at least a portion of the metal-including portion 25 is the same as the position in the Z-direction of the third semiconductor region 3. For example, the metal-including portion 25 is provided in a region positioned in the X-direction or the Y-direction from the third semiconductor region 3.

For example, a portion of the metal-including portion 25 is provided at the same height as the p-n junction surface between the second semiconductor region 2 and the third semiconductor region 3. Another portion of the metal-including portion 25 may be provided at the same height as a portion of the first semiconductor region 1. The potential of the metal-including portion 25 may be fixed or floating.

Favorably, the metal-including portion 25 is provided around the element 10 in the X-Y plane. The metal-including portion 25 may be provided only at a portion around the element 10 in the X-Y plane.

The conductive layer 32 is provided on the electrode 31. The element 10 and the structure body 20 are provided on the conductive layer 32. The second semiconductor region 2 is electrically connected to the electrode 31 via the first semiconductor region 1 and the conductive layer 32.

A voltage is applied between the second semiconductor region 2 and the third semiconductor region 3 by controlling the potential of the electrode 31. For example, the element 10 functions as an avalanche photodiode.

A semiconductor region 4 of the first conductivity type may be provided between the conductive layer 32 and the structure body 20. The p-type impurity concentration in the semiconductor region 4 is greater than the p-type impurity concentration in the first semiconductor region 1. When the conductive layer 32 is a p-type semiconductor layer, the p-type impurity concentration in the semiconductor region 4 is less than the p-type impurity concentration in the conductive layer 32.

As illustrated in FIGS. 1 and 2, multiple elements 10 are provided in the X-direction and the Y-direction. As illustrated in FIG. 2, multiple structure bodies 20 may be provided respectively around the multiple elements 10. The multiple structure bodies 20 are separated from each other.

For example, a semiconductor region 5 of the first conductivity type is provided between the adjacent structure bodies 20. The p-type impurity concentration in the semiconductor region 5 is less than the p-type impurity concentration in the second semiconductor region 2 and less than the p-type impurity concentration in the semiconductor region 4.

The insulating layer 33 is provided on the element 10 and the structure body 20. The insulating layer 34 is provided on the insulating layer 33. The insulating layer 35 is provided on the insulating layer 34. The insulating layer 36 is provided on the insulating layer 35.

As shown in FIG. 2, the third semiconductor region 3 is electrically connected to the interconnect 41. For example, the third semiconductor region 3 is electrically connected to the interconnect 41 via a plug 41a, a metal layer 41b, a plug 41c, the quenching part 42, and a plug 41d.

The electrical resistance of the quenching part 42 is greater than the electrical resistances of the plug 41a, the metal layer 41b, the plug 41c, and the plug 41d. It is favorable for the electrical resistance of the quenching part 42 to be not less than 50 kΩ and not more than 2 MΩ.

For example, at least a portion of the quenching part 42 is provided on the semiconductor region 5 with the insulating layer 33 interposed. The quenching part 42 is not provided on the element 10. Shielding by the quenching part 42 of the light that travels toward the element 10 can be suppressed thereby.

The quenching part 42 is provided to suppress the continuation of the avalanche breakdown that occurs when light enters the element 10. A voltage drop that corresponds to the electrical resistance of the quenching part 42 occurs when avalanche breakdown occurs and a current flows in the quenching part 42. The potential difference between the second semiconductor region 2 and the third semiconductor region 3 is reduced by the voltage drop, and the avalanche breakdown stops. The next light that is incident on the element 10 can be detected thereby.

For example, the element 10 operates in a Geiger mode in which a reverse voltage that is greater than the breakdown voltage is applied between the second semiconductor region 2 and the third semiconductor region 3. For example, a voltage of -25 V to -35 V with respect to the pad 43 is applied to the electrode 31. By operating in the Geiger mode, a pulse signal that has a high gain and a short time constant is output.

As described above, a resistor that generates a large voltage drop may be provided as the quenching part 42; conversely, instead of a resistor, a control circuit that blocks the current may be provided as the quenching part 42. For example, the control circuit includes a comparator, a control logic part, and two switching elements. A known configuration called an active quenching circuit is applicable to the control circuit.

The upper end of the metal-including portion 25 is positioned above the element 10 (the third semiconductor region 3) and positioned lower than the interconnect 41 and the metal layer 41b. For example, the upper end of the metal-including portion 25 is positioned higher than the quenching part 42.

For example, as shown in FIGS. 1 and 2, multiple interconnects 41 are provided in the X-direction. The interconnects 41 each extend along the Y-direction. The multiple interconnects 41 are electrically connected to the pad 43. As shown in FIG. 1, multiple pads 43 may be provided.

Examples of materials of the components will now be described.

The second semiconductor region 2, the third semiconductor region 3, the first semiconductor region 1, the semiconductor region 4, and the semiconductor region 5 include at least one semiconductor material selected from the group consisting of silicon, silicon carbide, gallium arsenide, and gallium nitride. Phosphorus, arsenic, or antimony may be used as the n-type impurity when these semiconductor regions include silicon. Boron may be used as the p-type impurity.

The p-type impurity concentration in the second semiconductor region 2 is, for example, not less than 1.0×10¹⁶ atoms/cm³ and not more than 1.0×10¹⁸ atoms/cm³. The n-type impurity concentration in the third semiconductor region 3 is, for example, not less than 1.0×10¹⁸ atoms/cm³ and not more than 1.0×10²¹ atoms/cm³. The p-type impurity concentrations in the first semiconductor region 1, the semiconductor region 4, and the semiconductor region 5 are, for example, not less than 1.0×10¹³ atoms/cm³ and not more than 1.0×10¹⁶ atoms/cm³.

The first insulating portion 21, the second insulating portion 22, and the insulating layers 33 to 36 include insulating materials. The refractive indexes of the insulating materials included in the first and second insulating portions 21 and 22 are less than the refractive index of the semiconductor material included in the element 10. For example, the first insulating portion 21, the second insulating portion 22, and the insulating layers 33 to 36 include silicon and one selected from the group consisting of oxygen and nitrogen. For example, the first insulating portion 21, the second insulating portion 22, and the insulating layers 33 to 36 include silicon oxide or silicon nitride.

The metal-including portion 25 includes a metal. For example, the metal-including portion 25 includes at least one selected from the group consisting of tungsten, aluminum, and copper. The metal-including portion 25 may include a compound of a metal and silicon. For example, the metal-including portion 25 includes tungsten silicide. Therefore, compared to the first and second insulating portions 21 and 22, the metal-including portion 25 easily reflects light.

The metal-including portion 25 may include a first layer 25a and a second layer 25b. The second layer 25b is provided between the first layer 25a and the first insulating portion 21, between the first layer 25a and the second insulating portion 22, and between the first layer 25a and the insulating layer 33. For example, the first layer 25a includes tungsten. The second layer 25b includes titanium. The second layer 25b may include a titanium layer and a titanium nitride layer. The titanium nitride layer is provided between the titanium layer and the first layer 25a.

The first insulating portion 21 and the second insulating portion 22 may include different materials from those described above as long as the refractive indexes of the materials included in the first and second insulating portions 21 and 22 are less than the refractive indexes of the materials included in the second and third semiconductor regions 2 and 3. Another member may be provided instead of the metal-including portion 25 as long as the other member absorbs or reflects light more easily than the first insulating portion 21 and the second insulating portion 22. For example, the other member may include carbon and may be black.

The conductive layer 32 is, for example, a p-type semiconductor region. The conductive layer 32 includes the semiconductor materials described above. The p-type impurity concentration in the conductive layer 32 is not less than 1.0×10¹⁷ atoms/cm³ and not more than 1.0×10²¹ atoms/cm³. Or, the conductive layer 32 may include a metal. For example, the conductive layer 32 includes at least one selected from the group consisting of aluminum, copper, titanium, gold, and nickel.

The quenching part 42 that is used as the resistor includes polysilicon as a semiconductor material. An n-type impurity or a p-type impurity may be added to the quenching part 42.

The plugs 41a, 41c, and 41d include metal materials. For example, the plugs 41a, 41c, and 41d include at least one selected from the group consisting of titanium, tungsten, copper, and aluminum. The plugs 41a, 41c, and 41d may include a conductor made of a silicon compound or a nitride of at least one selected from the group consisting of titanium, tungsten, copper, and aluminum. As shown in FIG. 3, each plug may include metal layers ML1 and ML2. The metal layer ML2 is provided between the metal layer ML1 and the insulating layers. For example, the metal layer ML1 includes tungsten. The metal layer ML2 includes titanium. The metal layer ML2 may include a titanium layer, and a titanium nitride layer provided between the titanium layer and the metal layer ML1.

The electrode 31, the interconnect 41, the metal layer 41b, and the pad 43 include at least one selected from the group consisting of copper and aluminum.

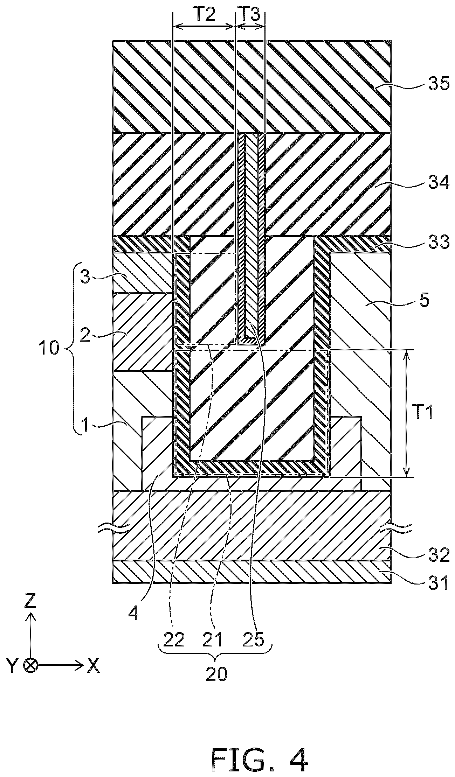

FIG. 4 is an enlarged view of a portion of FIG. 3.

As shown in FIG. 4, a thickness T1 in the Z-direction of the first insulating portion 21 is greater than a thickness T2 in the X-Y plane of the second insulating portion 22 between the element 10 and the metal-including portion 25. For example, the thickness T1 is greater than a thickness T3 of the metal-including portion 25 in a direction from the element 10 toward the metal-including portion 25. The thickness T2 may be greater or less than the thickness T3. For example, the thickness T2 is less than the thickness T3.

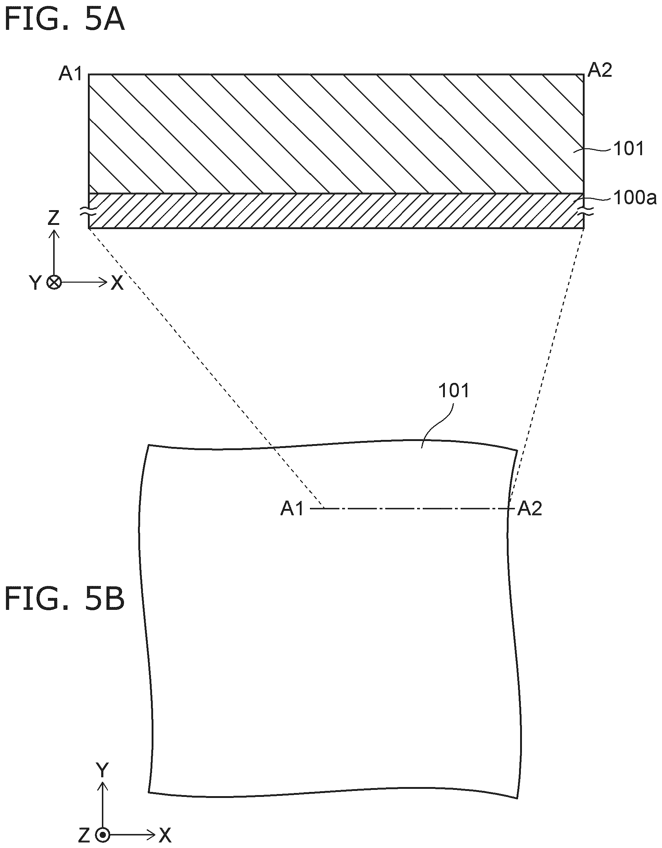

FIGS. 5A to 17B are schematic views illustrating manufacturing processes of the light detector according to the first embodiment.

FIGS. 5A to 16A respectively show A1-A2 cross sections of FIGS. 5B to 16B. An example of manufacturing processes of the light detector according to the first embodiment will be described with reference to FIGS. 5A to 17B.

As shown in FIGS. 5A and 5B, a substrate that includes a silicon substrate 100a and a p-type silicon epitaxial layer 101 is prepared. The direction from the silicon substrate 100a toward the silicon epitaxial layer 101 corresponds to the Z-direction. The silicon epitaxial layer 101 is formed by epitaxially growing silicon on the silicon substrate 100a. The silicon substrate 100a and the silicon epitaxial layer 101 include single-crystal p-type silicon doped with boron. The boron concentration in the silicon substrate 100a is 4.0×10¹³ cm⁻³. The boron concentration in the silicon epitaxial layer 101 is 1.0×10¹⁵ cm⁻³. The thickness of the silicon epitaxial layer 101 is 10 µm.

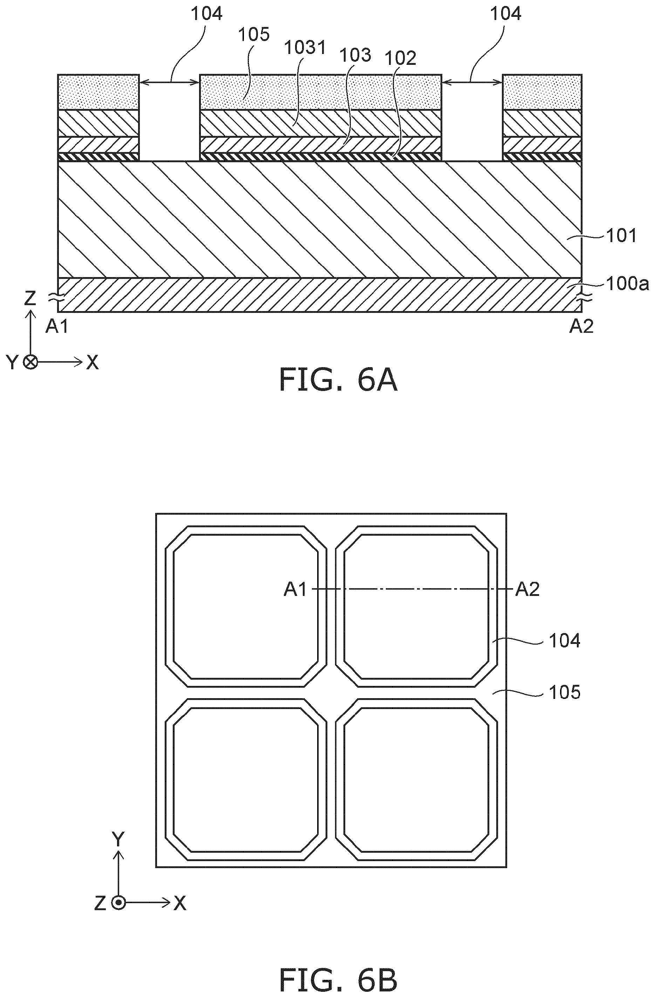

As shown in FIGS. 6A and 6B, a silicon oxide film 102 that has a thickness of 100 nm is formed by oxidizing the surface of the silicon epitaxial layer 101. A silicon nitride film 103 of 150 nm is deposited on the silicon oxide film 102 by low pressure thermal CVD. A silicon oxide film 1031 of 1 µm is deposited on the silicon nitride film 103 by low pressure thermal CVD. A resist 105 that defines an element separation region 104 is formed by a lithography process. The silicon oxide film 1031, the silicon nitride film 103, and the silicon oxide film 102 are etched via an opening of the resist 105 by reactive ion etching (RIE). The width of the element separation region 104 is 1.8 µm.

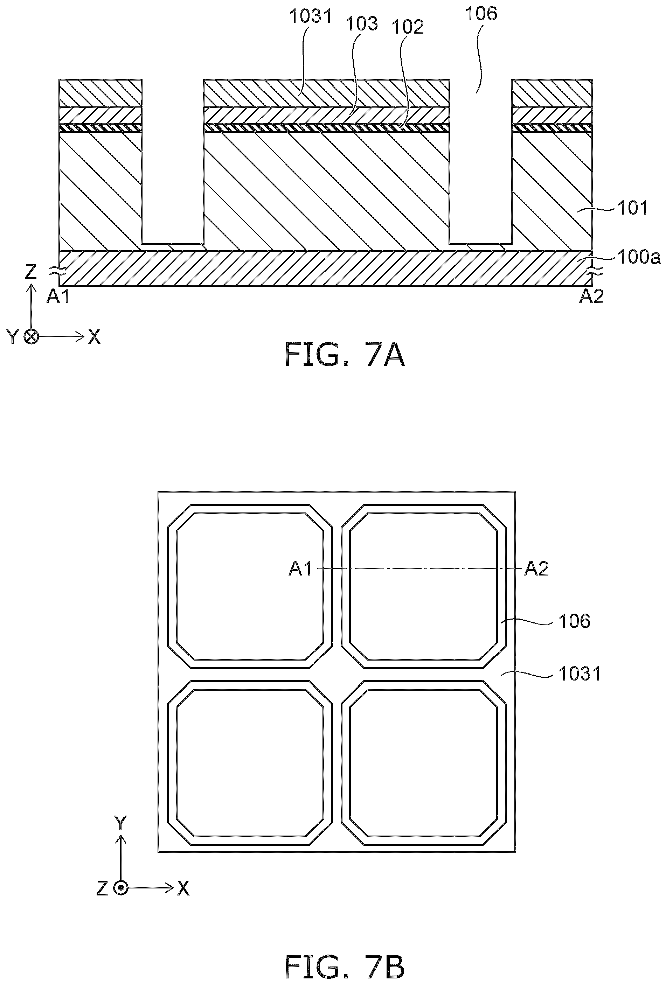

The resist 105 is stripped away as shown in FIGS. 7A and 7B. The silicon epitaxial layer 101 of the element separation region 104 is etched using the silicon oxide film 1031 as a mask. A first trench 106 is formed thereby. At this time, the depth of the etching is determined by the thickness of the silicon epitaxial layer 101 and the diffusion amount into the silicon epitaxial layer 101 of the boron included in the silicon substrate 100a. The diffusion amount is determined by considering the heating processes of the entire process. The etching depth is, for example, 9 µm. It is favorable to provide a taper angle of about 2° when forming the first trench 106. The taper angle is the tilt of the side surface of the first trench 106 with respect to the Z-direction. The occurrence of voids when subsequently filling with an oxide film can be suppressed thereby.

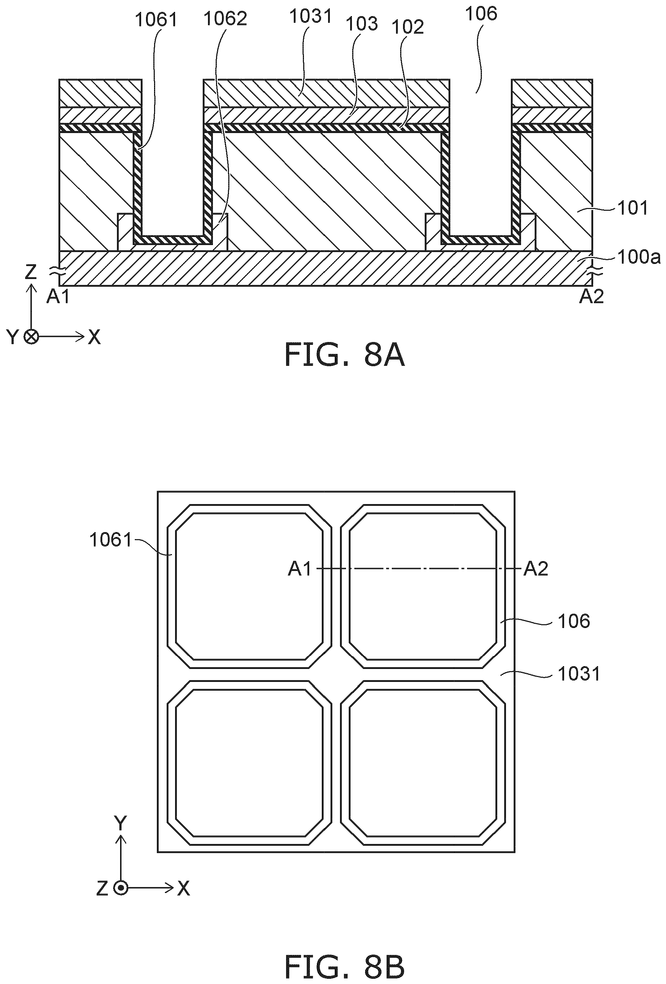

As shown in FIGS. 8A and 8B, a silicon oxide film 1061 that has a thickness of 50 nm is formed by oxidizing the surface of the first trench 106. An implantation region 1062 may be formed at the bottom portion of the first trench 106 by performing ion implantation into the entire substrate surface. The implantation region 1062 is formed by ion implantation of boron with an implantation acceleration voltage of 40 keV, an implantation dose of 2.5×10¹² cm⁻², and an angle from the substrate normal direction set to 0 degrees. If the angle is set to ±30 degrees at this time, the implantation region 1062 is formed also at the bottom portion side surface of the first trench 106 as shown in FIG. 8A. Crystal defects occur in the silicon epitaxial layer 101 when forming the first trench 106 by RIE. A noise component caused by the defects can be suppressed by forming the implantation region 1062 at the bottom portion side surface of the first trench 106.

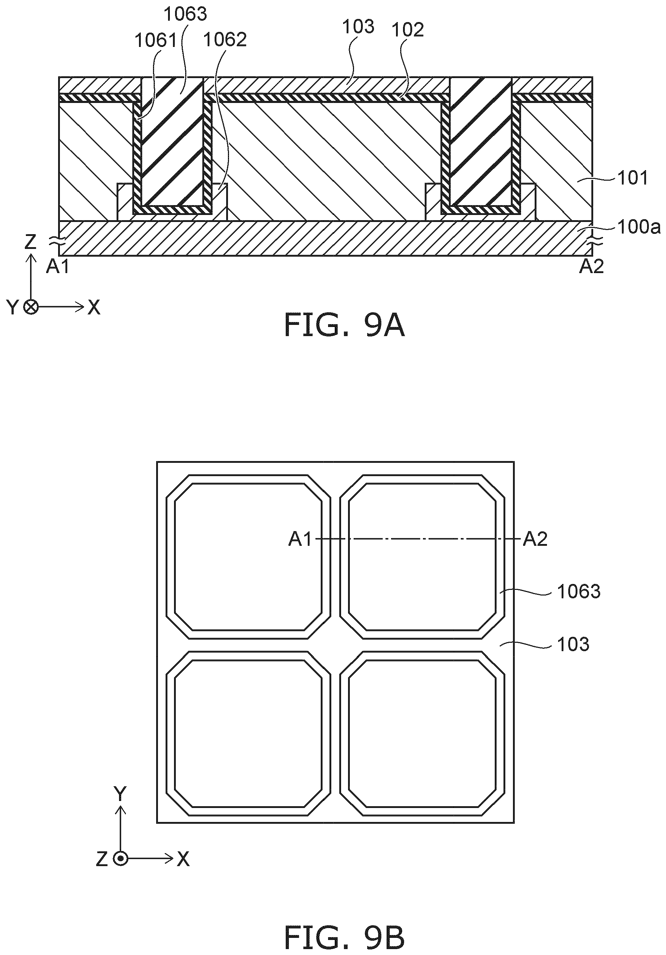

As shown in FIGS. 9A and 9B, an oxide film 1063 of 1.2 µm is deposited by plasma-enhanced chemical vapor deposition (CVD). The structure of the oxide film 1063 is densified by performing nitrogen annealing at 1000 °C. The oxide film 1063 is planarized by chemical mechanical polishing (CMP) processing using the silicon nitride film 103 as a stopper.

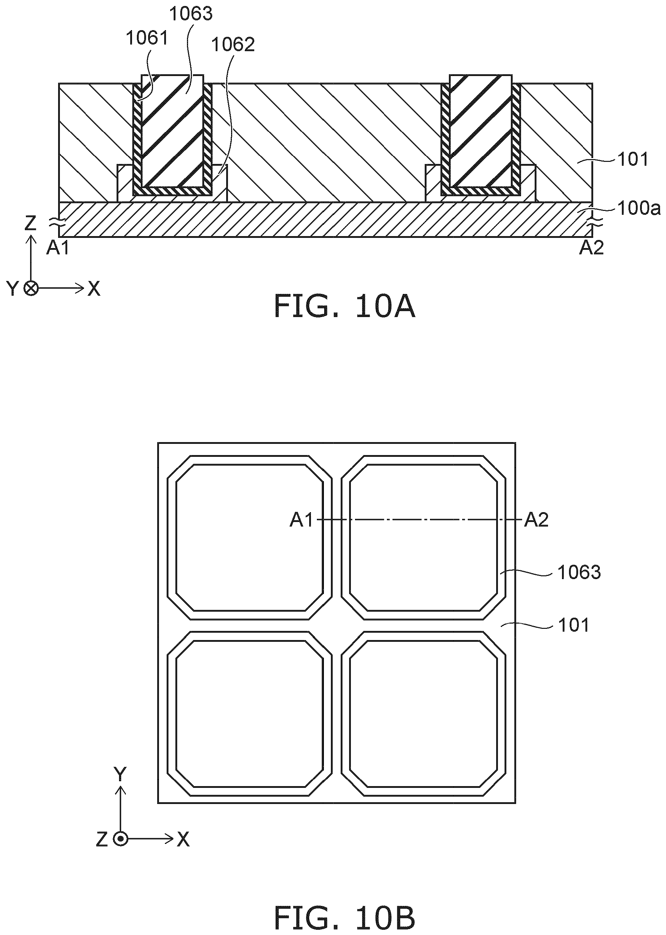

As shown in FIGS. 10A and 10B, the silicon nitride film 103 is stripped away by hot phosphoric acid treatment. The silicon oxide film 102 is stripped away by hydrofluoric acid treatment.

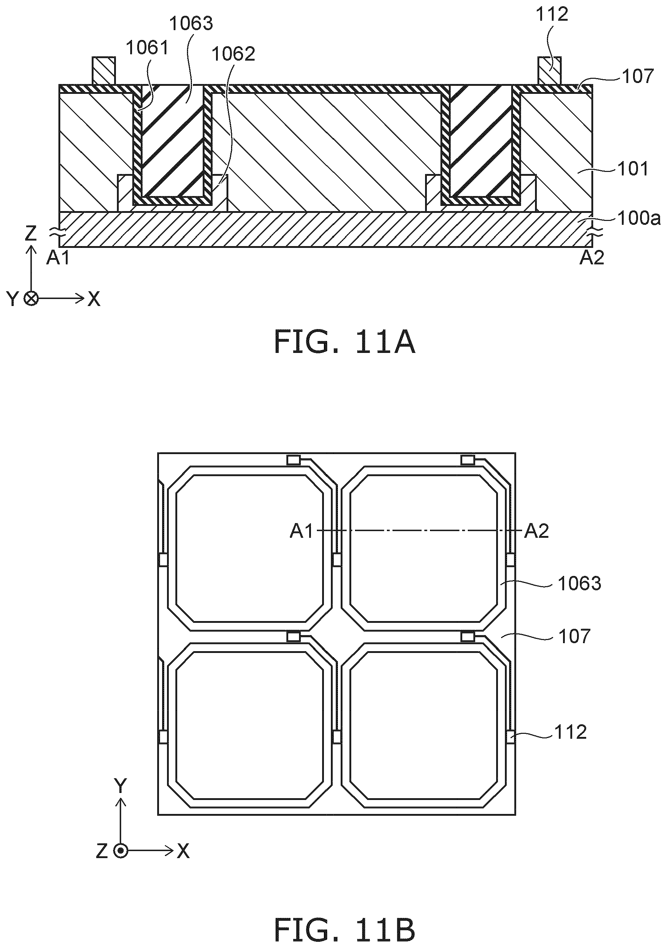

As shown in FIGS. 11A and 11B, a silicon oxide film 107 that has a thickness of 50 nm is formed by oxidizing the surface of the silicon epitaxial layer 101. A polysilicon film that has a thickness of 0.2 µm is formed by low pressure thermal CVD. A quenching resistance 112 is formed by patterning the silicon oxide film 107 and the polysilicon film into a prescribed shape by a lithography process and an RIE process. To adjust the resistance of the quenching resistance 112, for example, 1.0×10¹³ cm⁻² of an impurity is implanted by implanting boron with an implantation acceleration voltage of 20 keV and by performing an activation anneal.

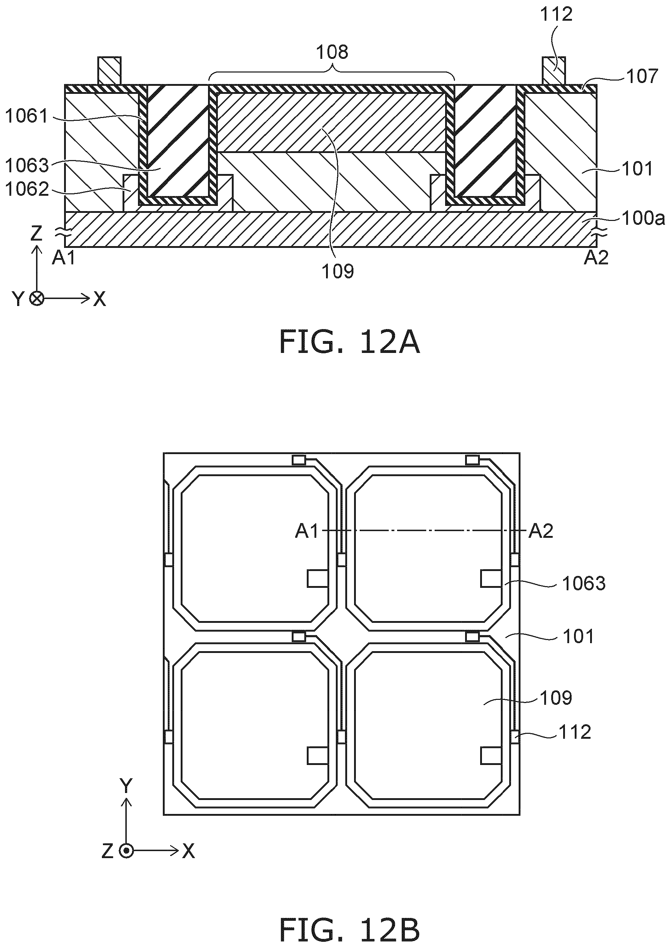

As shown in FIGS. 12A and 12B, a p-type avalanche layer 109 is formed and patterned in an element region 108 by a lithography process and an ion implantation process. The silicon oxide film 107 is not illustrated in FIGS. 12B to 18B. The p-type avalanche layer 109 is formed by ion implantation of boron. The p-type avalanche layer 109 is formed so that the boron has a peak depth of 0.8 µm and a peak concentration of 1.0×10¹⁷ cm⁻³.

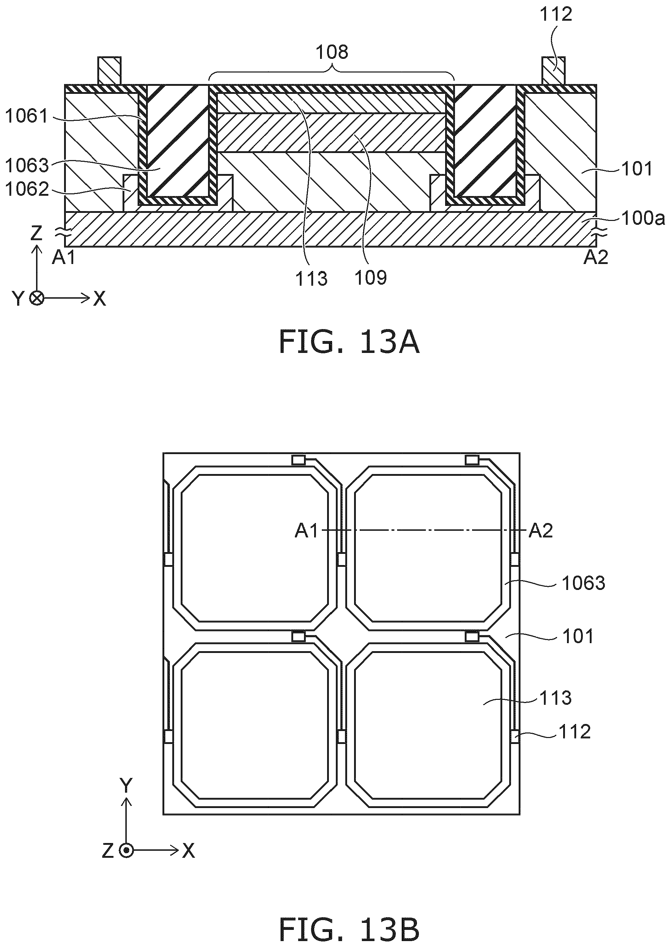

As shown in FIGS. 13A and 13B, an n-type avalanche layer 113 is formed and patterned by a lithography process and an ion implantation process. The n-type avalanche layer 113 is formed in the element region 108. The n-type avalanche layer 113 also is used as an ohmic electrode portion between the semiconductor region and the interconnect, which includes a metal. The n-type avalanche layer 113 is formed by ion implantation of phosphorus. The n-type avalanche layer 113 is formed so that the phosphorus has a peak positioned at the surface of the substrate and a peak concentration of 1.5×10²⁰ cm⁻³. Annealing is performed in a N₂ atmosphere to activate the n-type avalanche layer 113.

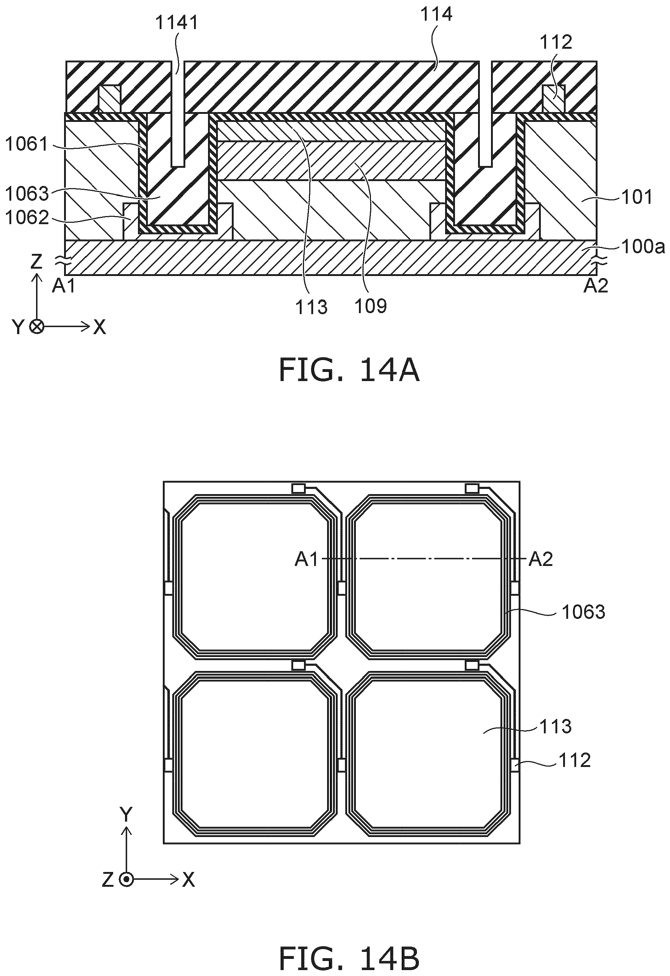

An insulating film 114 that has a thickness of 0.5 µm is formed by CVD. As shown in FIGS. 14A and 14B, a second trench 1141 that extends through the insulating film 114 and reaches the oxide film 1063 is formed by a lithography process and an RIE process. For example, the width of the second trench 1141 is 0.6 µm. The depth of the second trench 1141 from the silicon epitaxial layer 101 upper surface is 3 µm. The insulating film 114 is not illustrated in FIGS. 14B to 18B.

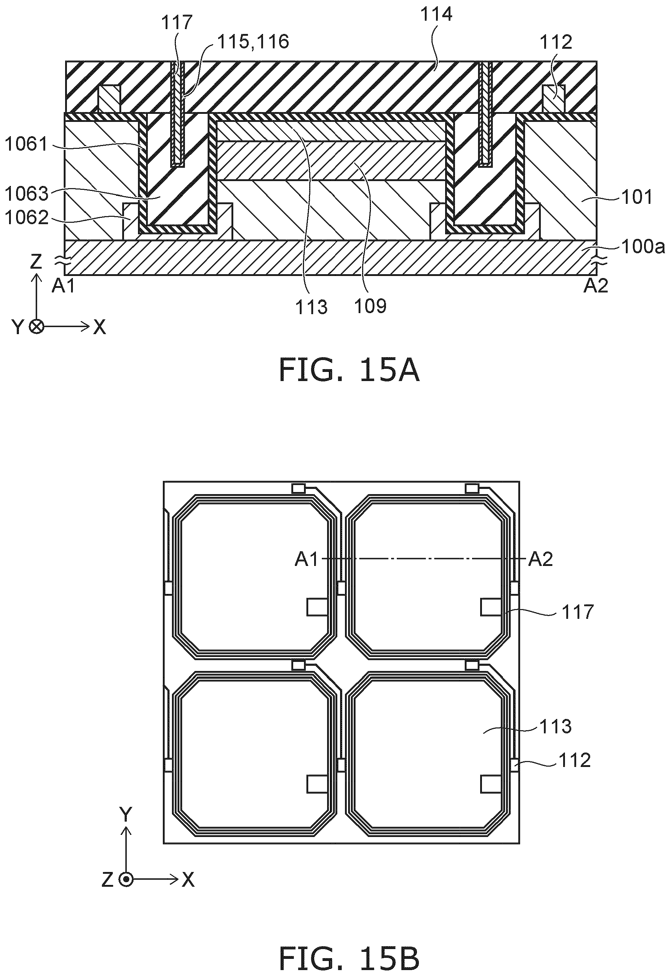

As shown in FIGS. 15A and 15B, a titanium film 115 of 50 nm and a titanium nitride film 116 of 50 nm are formed by sputtering along the inner wall of the second trench 1141. A tungsten film 117 of 400 nm is formed by CVD to fill the second trench 1141. The tungsten film 117, the titanium nitride film 116, and the titanium film 115 are planarized by CMP using the insulating film 114 as a stopper. Instead of the tungsten film 117, a layer of another material that reflects or absorbs light more easily than the oxide film 1063 may be provided.

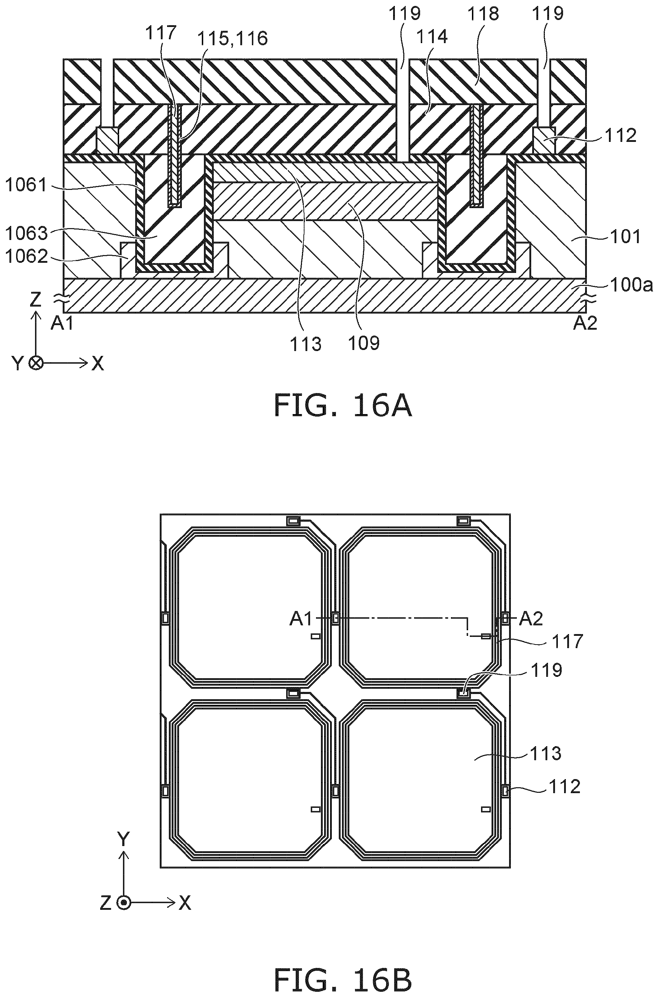

As shown in FIGS. 16A and 16B, an insulating film 118 that has a thickness of 0.3 µm is formed by CVD. Multiple contact holes 119 are formed in the insulating film 118, the insulating film 114, and the silicon oxide film 107 by a lithography process and an RIE process. A portion of the quenching resistance 112 and a portion of the n-type avalanche layer 113 are exposed via the multiple contact holes 119. The insulating film 118 is not illustrated in FIGS. 16B to 18B.

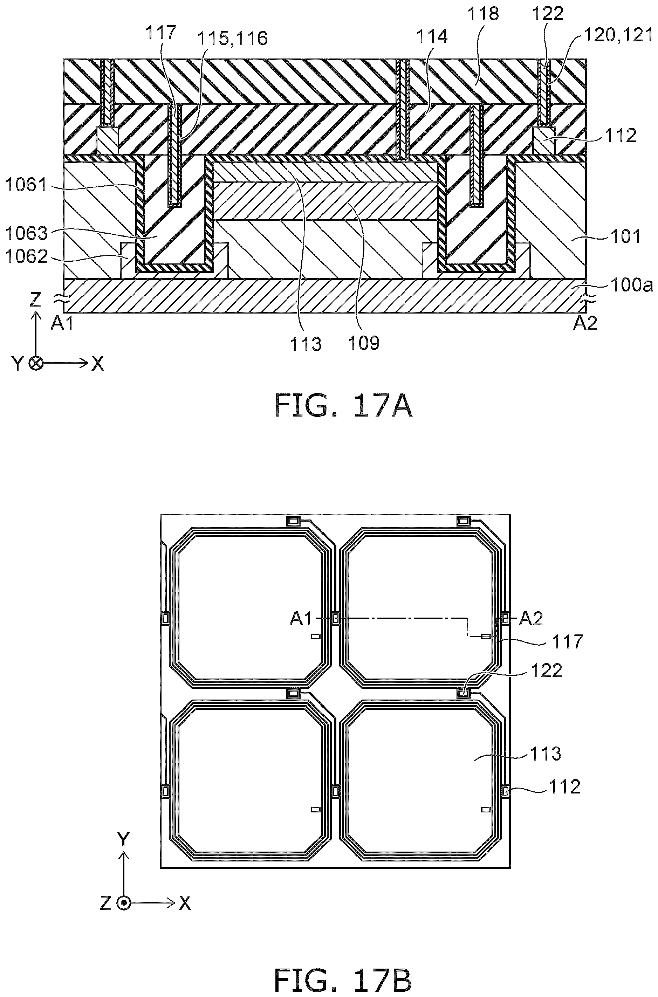

As shown in FIGS. 17A and 17B, a titanium film 120 of 10 nm and a titanium nitride film 121 of 10 nm are formed by sputtering. A tungsten film 122 of 0.3 µm is formed by CVD. The contact holes 119 are filled by planarizing the tungsten film 122, the titanium nitride film 121, and the titanium film 120 by CMP using the insulating film 118 as a stopper.

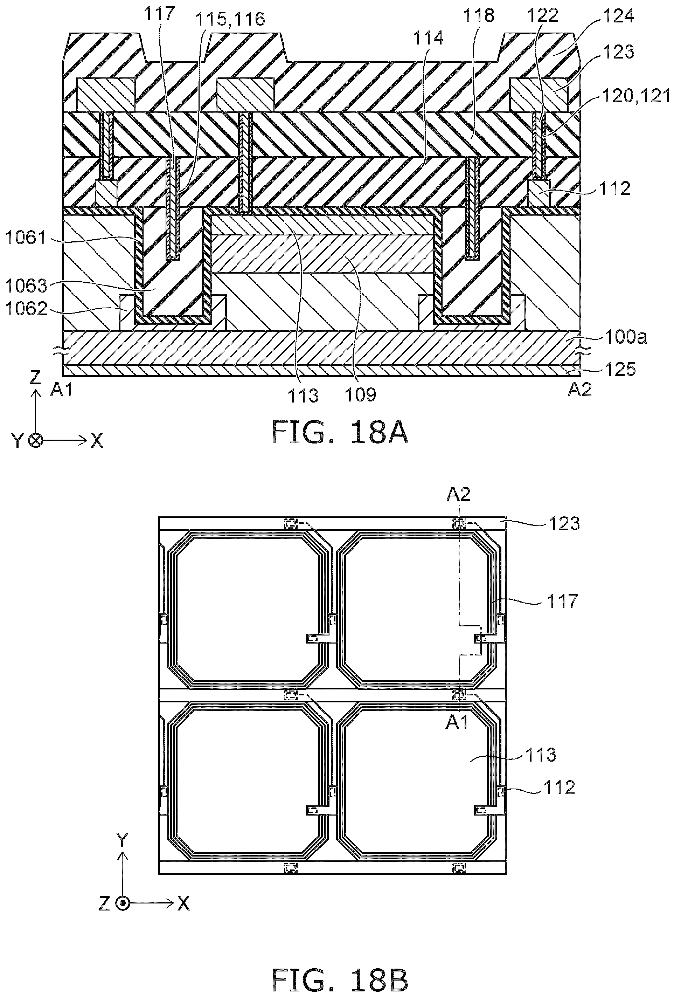

As shown in FIGS. 18A and 18B, an aluminum layer 123 that has a thickness of 0.5 µm is formed by sputtering. The aluminum layer 123 is patterned into a prescribed shape by a lithography process and an RIE process. A silicon nitride film that has a thickness of 0.3 µm is formed by CVD as a passivation film 124.

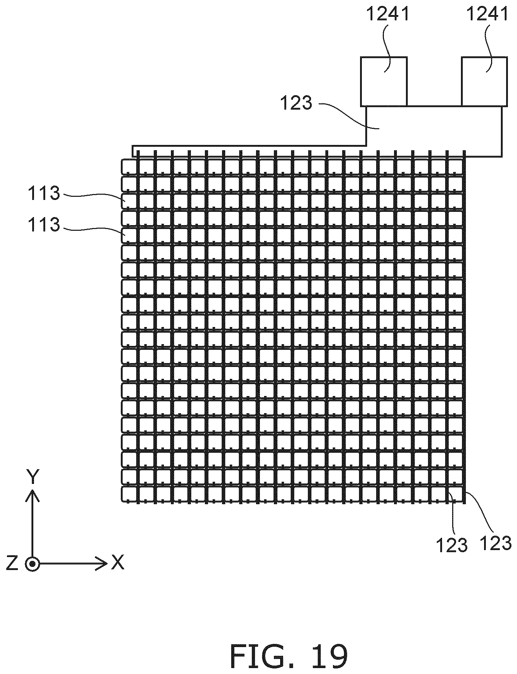

As shown in FIG. 19, openings are formed in the passivation film 124 by RIE, and a pad 1241 is exposed. The back surface of the silicon substrate 100a is polished until the thickness of the silicon substrate 100a is 600 µm. A Ti film and a Au film are formed as a back electrode 125. Thereby, the anode electrode of the avalanche photodiode is at the pad 1241 side. The cathode electrode is at the back electrode 125 side. The light detector 100 according to the first embodiment is manufactured by the processes described above.

The back electrode 125 of the manufacturing processes described above corresponds to the electrode 31 of the light detector 100. The silicon substrate 100a corresponds to the conductive layer 32. A portion of the silicon epitaxial layer 101 corresponds to the first semiconductor region 1 and the semiconductor region 5. The implantation region 1062 corresponds to the semiconductor region 4. The p-type avalanche layer 109 corresponds to the second semiconductor region 2. The n-type avalanche layer 113 corresponds to the third semiconductor region 3. The silicon oxide film 1061 and the oxide film 1063 correspond to the first insulating portion 21, the second insulating portion 22, and a third insulating portion 23. The titanium film 115, the titanium nitride film 116, and the tungsten film 117 correspond to the metal-including portion 25. The silicon oxide film 107 corresponds to the insulating layer 33. The insulating film 114 corresponds to the insulating layer 34. The insulating film 118 corresponds to the insulating layer 35. The passivation film 124 corresponds to the insulating layer 36. The quenching resistance 112 corresponds to the quenching part 42. The titanium film 120, the titanium nitride film 121, and the tungsten film 122 correspond to plugs. The aluminum layer 123 corresponds to the interconnect 41. The pad 1241 corresponds to the pad 43.

Effects of the first embodiment will now be described.

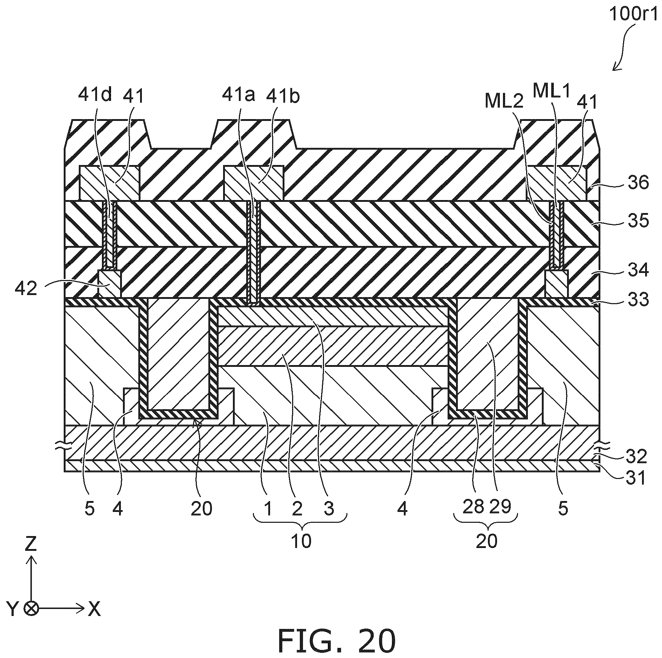

FIG. 20 is a schematic cross-sectional view illustrating a light detector according to a reference example not forming part of the claimed invention.

In the light detector 100r1 according to the reference example as shown in FIG. 20, the structure body 20 includes an insulating layer 28 and a metal layer 29. The insulating layer 28 is provided between the metal layer 29 and the semiconductor regions. The thickness of the insulating layer 28 is substantially constant. Compared to the insulating layer 28, the metal layer 29 easily reflects light. Because the structure body 20 includes the metal layer 29, the penetration of secondary photons from one element 10 into the adjacent elements 10 can be suppressed. The crosstalk noise of the light detector 100r1 can be reduced thereby.

To increase the sensitivities of the light detectors 100 and 100r1, it is desirable to increase the thickness in the Z-direction of the first semiconductor region 1. Light that has a long wavelength and enters a deep region of the element 10 can be detected by increasing the thickness of the first semiconductor region 1. When the thickness of the first semiconductor region 1 is increased, it is desirable for the depth of the structure body 20 also to be increased according to the increase of the thickness of the first semiconductor region 1. If the thickness of the first semiconductor region 1 is increased without changing the depth of the structure body 20, the movement of carriers and/or the penetration of secondary photons easily occur from one element 10 toward the adjacent elements 10 via the region below the structure body 20. In other words, the crosstalk noise increases.

In the light detector 100r1, the structure body 20 is formed by filling the metal layer 29 into the insulating layer 28. Compared to an insulating material, the step coverage generally degrades when depositing a metal material. Therefore, when the thickness of the first semiconductor region 1 is increased and the depth of the structure body 20 is increased, it is difficult to fill the metal layer 29. For example, when a void occurs at the surface of the metal layer 29, residue of a resist of a subsequent lithography process enters the void. The residue of the resist causes organic contamination of the manufacturing apparatuses, layer-shaped dust, etc. Accordingly, according to the light detector 100r1 according to the reference example, the structure body 20 cannot be deep, and the crosstalk noise also undesirably increases when increasing the sensitivity.

For this problem, in the light detector 100 according to the first embodiment, the structure body 20 includes the first insulating portion 21, the second insulating portion 22, and the metal-including portion 25. The first insulating portion 21 is provided below the metal-including portion 25. The thickness in the Z-direction of the first insulating portion 21 can be easily increased according to the increase of the thickness in the Z-direction of the first semiconductor region 1. As a result, for example, as shown in FIG. 4, the thickness T1 of the first insulating portion 21 is greater than the thickness T2 of at least a portion of the second insulating portion 22. According to the first embodiment, the sensitivity of the light detector 100 can be increased while suppressing the increase of the crosstalk noise of the light detector 100.

For example, according to the first embodiment, the thickness in the Z-direction of the first semiconductor region 1 can be 6 µm or more. Even when the thickness of the first semiconductor region 1 is 6 µm or more, the structure body 20 that corresponds to the thickness of the first semiconductor region 1 can be formed around the element 10. According to the first embodiment, the thickness of the first semiconductor region 1 can be further increased to be 10 µm or more. Thereby, the sensitivity of the light detector 100 can be further increased while suppressing the increase of the crosstalk noise of the light detector 100.

In the example described herein, the structure body 20 includes the first insulating portion 21, the second insulating portion 22, and the metal-including portion 25. Instead of the metal-including portion 25, the structure body 20 may include another member that easily reflects or absorbs light. The other member is, for example, black or white. The other member may be conductive or insulative. For example, the other member may include carbon black.

For example, the structure body 20 may include first to third portions. The second and third portions are provided above the first portion. The third portion is provided between the element 10 and the second portion. In other words, the first portion is provided at a position corresponding to the first insulating portion 21. The second portion is provided at a position corresponding to the metal-including portion 25. The third portion is provided at a position corresponding to the second insulating portion 22. The refractive indexes of the materials included in the first and third portions are less than the refractive index of the semiconductor material included in the element 10. The second portion absorbs or reflects light more easily than the first and third portions. The thickness in the Z-direction of the first portion is greater than the thickness of the third portion between the element 10 and the second portion. By using this structure body 20, similarly to the light detector 100 that is illustrated, the sensitivity of the light detector 100 can be increased while suppressing the increase of the crosstalk noise of the light detector 100.

When light enters the element 10, secondary photons are generated mainly at the interface (the p-n junction surface) between the second semiconductor region 2 and the third semiconductor region 3. It is favorable for the metal-including portion 25 to be arranged with the interface in the X-direction or the Y-direction. The penetration of the secondary photons into the adjacent elements 10 can be effectively suppressed thereby. As a result, the crosstalk noise of the light detector 100 can be reduced.

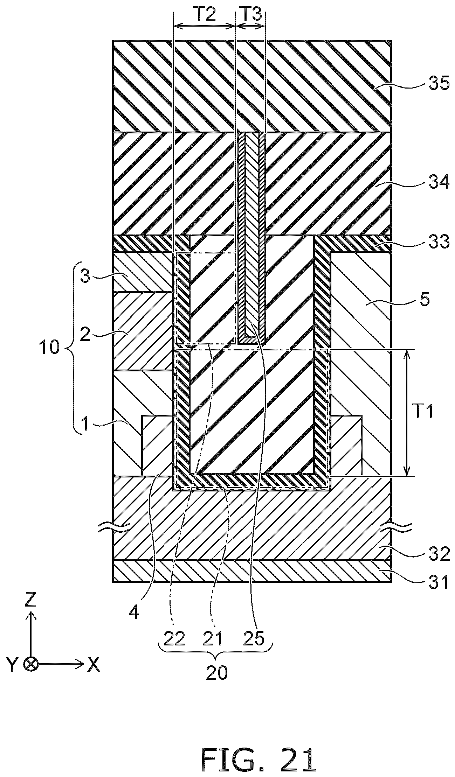

FIG. 21 is a schematic cross-sectional view illustrating a portion of the light detector according to the first embodiment.

The structure body 20 may be separated from the conductive layer 32 as shown in FIG. 4, or may contact the conductive layer 32 as shown in FIG. 21. The lower end of the structure body 20 may be positioned lower than the upper surface of the conductive layer 32.

When the structure body 20 is separated from the conductive layer 32, the thickness of the first semiconductor region 1 can be increased in the manufacturing processes of the light detector 100 regardless of the manufacturing processes (e.g., the etching process) of the structure body 20. Therefore, the sensitivity of the light detector 100 can be increased.

For example, the leakage current of the light detector 100 can be reduced when the structure body 20 contacts the conductive layer 32. This is due to the following reasons. In the manufacturing processes of the light detector 100, the first trench 106 is formed as illustrated in FIGS. 7A and 7B to form the structure body 20. At this time, defects that are caused by etching damage occur in the bottom surface of the first trench 106. When the light detector 100 in which the structure body 20 contacts the conductive layer 32 is manufactured, the first trench 106 that reaches the silicon substrate 100a is formed. In such a case, the defects in the bottom portion of the first trench 106 are filled with the carriers doped into the silicon substrate 100a. As a result, the defect density decreases and the leakage current of the light detector 100 that is manufactured is reduced.

It is favorable for the upper end of the metal-including portion 25 to be positioned above the third semiconductor region 3. However, it is difficult to form the metal-including portion 25 when the position of the upper end of the metal-including portion 25 is too high. Specifically, after an opening for the metal-including portion 25 is formed, it is difficult to fill the opening with a material. Also, the arrangement of the metal layer 41b, the interconnect 41, etc., is constrained. Therefore, it is favorable for the upper end of the metal-including portion 25 to be positioned lower than the interconnect 41.

For example, multiple structure bodies 20 are provided as shown in FIG. 2. The multiple structure bodies 20 are separated from each other. Compared to when one structure body 20 is provided, the number of interfaces of the structure body 20 between adjacent elements 10 is increased when the multiple structure bodies 20 are provided. By increasing the number of interfaces, the secondary photons that travel toward the adjacent elements 10 are reflected or absorbed more easily. The crosstalk noise can be further reduced thereby.

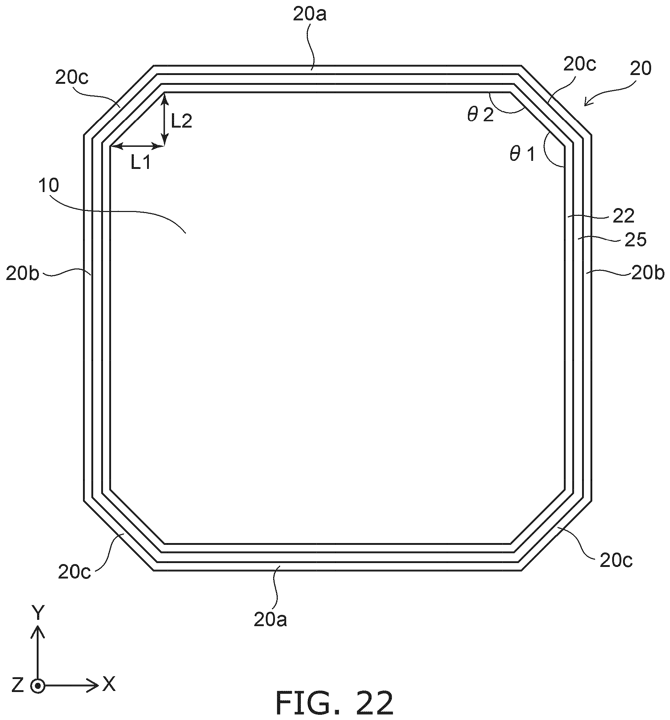

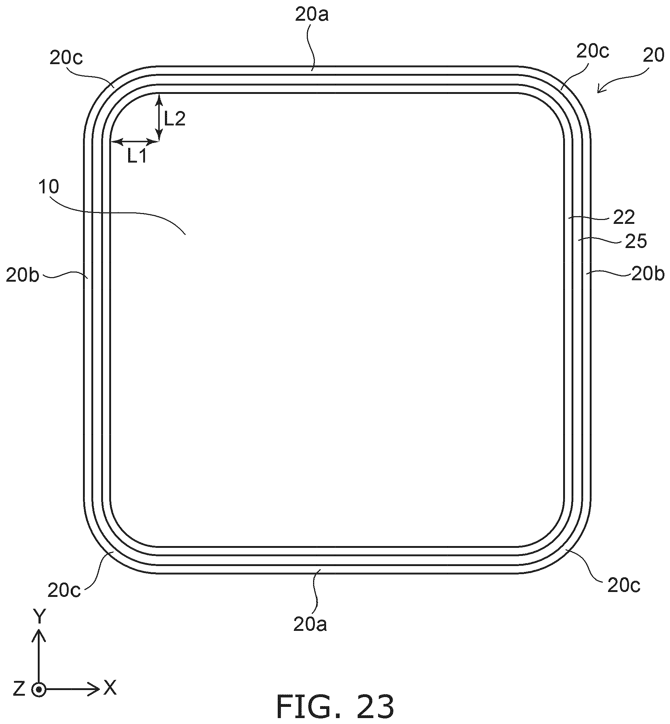

FIGS. 22 and 23 are schematic plan views illustrating a portion of the light detector according to the first embodiment.

For example, the structure body 20 is a five-or-higher-sided polygon when viewed from the Z-direction. In the example shown in FIG. 22, the structure body 20 is octagonal when viewed from the Z-direction. Specifically, the structure body 20 includes a pair of first extension portions 20a extending along the X-direction, a pair of second extension portions 20b extending along the Y-direction, and multiple link portions 20c. The element 10 is provided between the pair of first extension portions 20a in the Y-direction. The element 10 is provided between the pair of second extension portions 20b in the X-direction. Each link portion 20c links one end of the first extension portion 20a and one end of the second extension portion 20b.

The length in the X-direction of the first extension portion 20a is greater than the length in the X-direction of the link portion 20c. The length in the Y-direction of the second extension portion 20b is greater than the length in the Y-direction of the link portion 20c. For example, the link portion 20c has a straight-line shape when viewed from the Z-direction. It is favorable for an angle θ1 between the first extension portion 20a and the link portion 20c to be 135 degrees or more. It is favorable for an angle θ2 between the second extension portion 20b and the link portion 20c to be 135 degrees or more.

It is favorable for a length L1 in the X-direction of the link portion 20c and a length L2 in the Y-direction of the link portion 20c each to be 1 µm or more.

Or, as shown in FIG. 23, the corners of the structure body 20 may be curved when viewed from the Z-direction. In other words, the link portions 20c may be curved when viewed from the Z-direction. In the example shown in FIG. 23, the structure body 20 is a rounded rectangle when viewed from the Z-direction. For example, one end of the link portion 20c linked to the first extension portion 20a is along the X-direction. The other end of the link portion 20c linked to the second extension portion 20b is along the Y-direction. Thereby, the link portion 20c is smoothly linked to the first extension portion 20a and the second extension portion 20b.

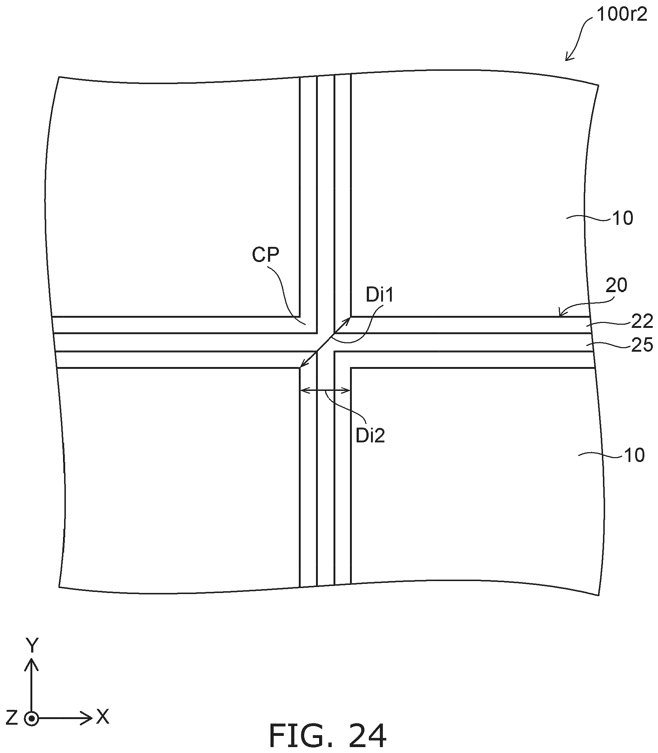

FIG. 24 is a schematic plan view illustrating a portion of a light detector according to a reference example not forming part of the claimed invention.

In the light detector 100r2 according to the reference example shown in FIG. 24, the structure body 20 is provided in a lattice configuration. Specifically, a portion of the structure body 20 extends along the X-direction. Another portion of the structure body 20 extends along the Y-direction. The corners of the element 10 are about 90 degrees at a crossing portion CP vicinity between the portion of the structure body 20 extending along the X-direction and the portion of the structure body 20 extending along the Y-direction. Compared to the other portions, a large stress is generated between the structure body 20 and the elements 10 at the crossing portion CP vicinity due to the protrusion of the corners of the element 10.

As shown in FIG. 22, when the structure body 20 is a five-or-higher-sided polygon when viewed from the Z-direction, the interior angles of the structure body 20 can be larger. For example, according to the structure shown in FIG. 22, the interior angle between the first extension portion 20a and the link portion 20c and the interior angle between the second extension portion 20b and the link portion 20c can be 135 degrees or more. Or, the corners of the structure body 20 can be curved when the structure body 20 is a rounded polygon when viewed from the Z-direction as shown in FIG. 23. According to these structures, the stress that is applied between the element 10 and the structure body 20 at the corners of the structure body 20 can be relaxed. For example, by relaxing the stress, the occurrence of cracks in the element 10 and the structure body 20 can be suppressed. Operation errors that are caused by the occurrence of cracks can be suppressed.

Also, if cracks occur in the silicon epitaxial layer 101, the silicon oxide film 1061, or the oxide film 1063 when forming the silicon oxide film 1061 and the oxide film 1063 corresponding to the structure body 20, there is a possibility that a resist in a subsequent photolithography process may enter the cracks. If the resist enters the cracks, a residue of the resist in the cracks occurs when the resist is stripped away. The residue of the resist causes organic contamination of oxidation ovens in subsequent heating processes such as oxidization. By relaxing the stress on the silicon epitaxial layer 101, the silicon oxide film 1061, and the oxide film 1063, the occurrence of cracks can be suppressed, and the yield of the light detector 100 can be increased.

In the structure of the structure body 20 shown in FIG. 24, a dimension Di1 in the oblique direction of the crossing portion CP is about 1.4 times a dimension Di2 in the X-direction or the Y-direction of the crossing portion CP. The oblique direction is perpendicular to the Z-direction and oblique to the X-direction and the Y-direction. In other words, at the portion where the crossing portion CP is formed in the process corresponding to FIGS. 8A and 8B when manufacturing the structure shown in FIG. 24, the dimension in the oblique direction of the first trench 106 is about 1.4 times the dimension Di2 in the X-direction or the Y-direction. Due to this dimensional difference, when forming the oxide film 1063 in the first trench 106, the first trench 106 is not completely filled into the crossing portion CP, and voids occur inside the oxide film 1063. Similarly to the cracks, the resist enters the voids, and a residue of the resist in the voids occurs. According to the structures shown in FIGS. 22 and 23, the local increase of the dimension of the first trench 106 can be avoided, and the occurrence of voids can be suppressed.

In the example shown in FIGS. 22 and 23, it is favorable for the lengths of the link portion 20c in the X-direction and the Y-direction each to be 1 µm or more. The stress that is generated at the link portion 20c vicinity can be effectively relaxed thereby.

In the example described herein, the structure body 20 includes the pair of first extension portions 20a, the pair of second extension portions 20b, and the multiple link portions 20c. It is sufficient for the structure body 20 to include at least one first extension portion 20a, one second extension portion 20b, and one link portion 20c connected to each other. Thereby, the stress at the vicinity of the region where the one first extension portion 20a, the one second extension portion 20b, and the one link portion 20c are provided can be relaxed.

The inventors made the light detector 100 according to the first embodiment with the following conditions. The shape of the structure body 20 when viewed from the Z-direction was octagonal. The spacing between the centers of the elements 10 was 25 µm. The width of the structure body 20 was 1.6 µm. The width of the structure body 20 corresponds to the length of the structure body 20 in the direction from the element 10 toward the structure body 20. The ratio of the sum of the surface area in the X-Y plane of the multiple elements 10 to the surface area in the X-Y plane of the conductive layer 32 was 0.6. The design was such that a depletion layer of 3 µm extended from the p-n junction surface of the element 10 toward the conductive layer 32.

For this light detector 100, a negative operating voltage *(Vop)* was applied to the electrode 31, and a pulse signal was read from the pad 43. The operating voltage was set in the range of -25 V to -35 V. Comparing the crosstalk noise of this light detector 100 and the crosstalk noise of the light detector 100r2 according to the reference example, the crosstalk noise of the light detector 100 was 30% less than the crosstalk noise of the light detector 100r2.

### Modification

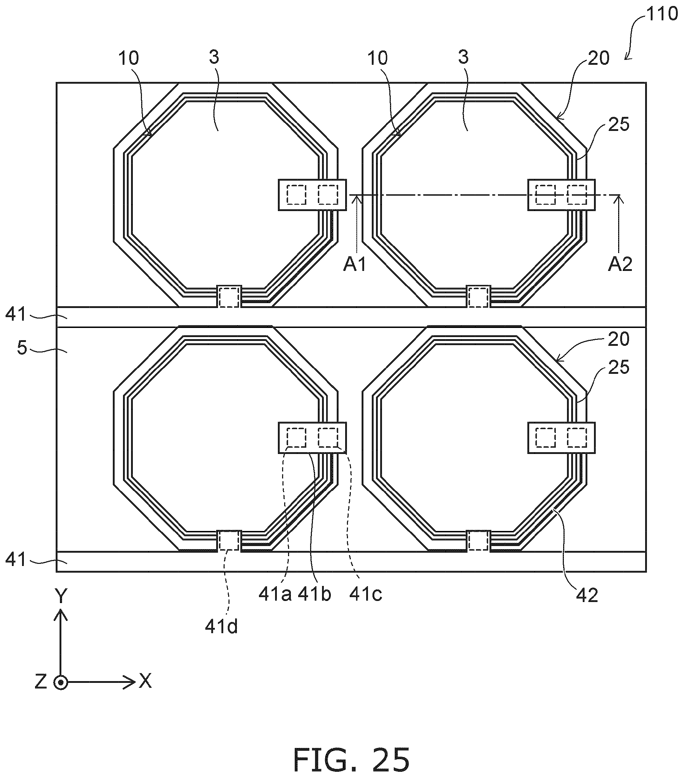

FIG. 25 is a schematic plan view illustrating a light detector according to a modification of the first embodiment.

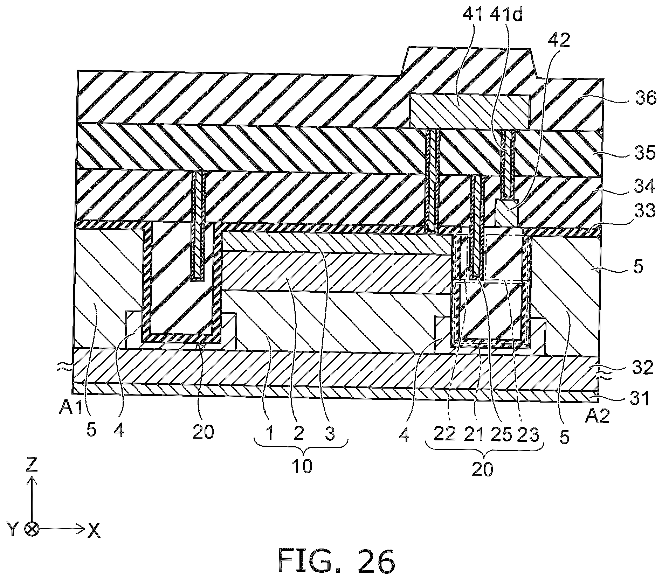

FIG. 26 is an A1-A2 cross-sectional view of FIG. 25.

In the light detector 110 according to the modification as shown in FIGS. 25 and 26, the quenching part 42 is provided on the structure body 20. For example, the quenching part 42 is provided at the same height as a portion of the metal-including portion 25. The quenching part 42 is separated from the metal-including portion 25 and is electrically isolated from the metal-including portion 25.

As one specific example, the structure body 20 further includes the third insulating portion 23 positioned between the metal-including portion 25 and the semiconductor region 5. The quenching part 42 is provided on the third insulating portion 23. For example, the thickness of the third insulating portion 23 between the metal-including portion 25 and the semiconductor region 5 is greater than the thickness of the second insulating portion 22 between the element 10 and the metal-including portion 25.

Compared to when the quenching part 42 is provided on the semiconductor region 5 with the insulating layer 33 interposed, the quenching part 42 can be more separated from the semiconductor regions when the quenching part 42 is provided on the structure body 20. The likelihood of dielectric breakdown occurring can be reduced even when a large voltage is applied to the quenching part 42. Thereby, for example, the design degrees of freedom of the breakdown voltage of the element 10 can be increased.

### Second embodiment

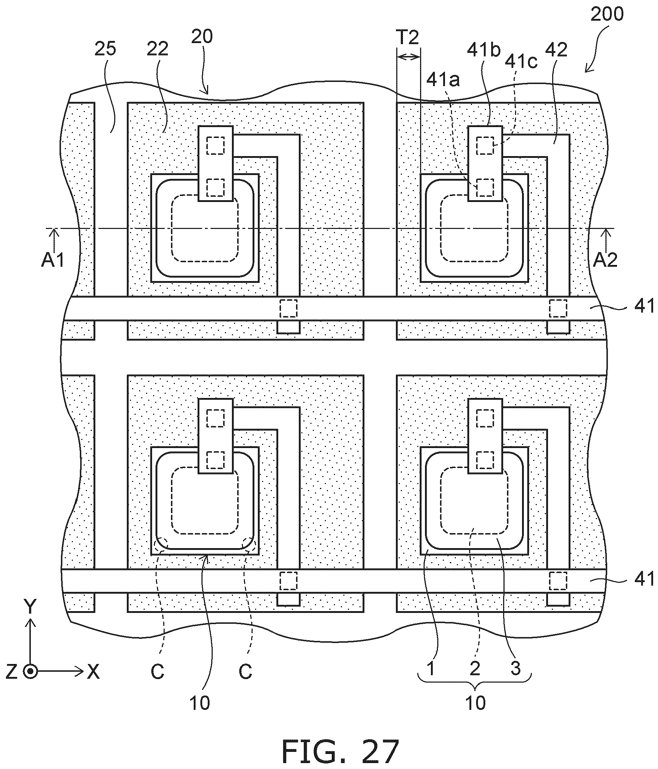

FIGS. 27 to 29 are schematic plan views illustrating a portion of a light detector according to a second embodiment.

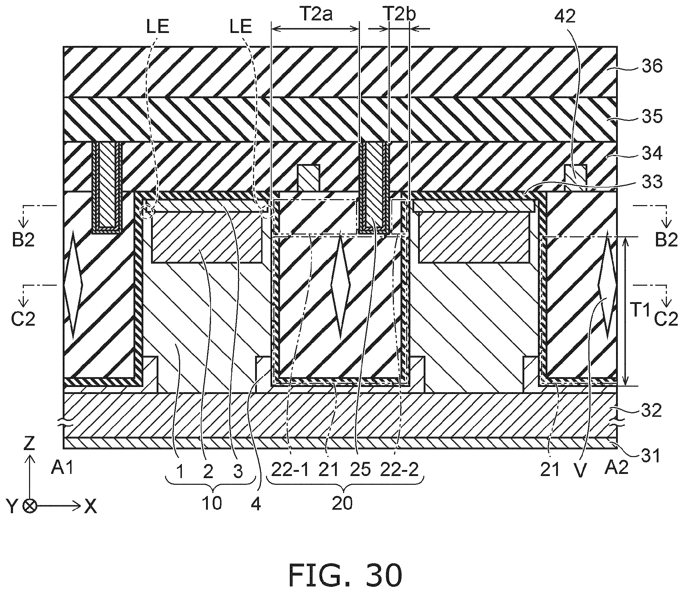

FIG. 30 is an A1-A2 cross-sectional view of FIGS. 27 to 29.

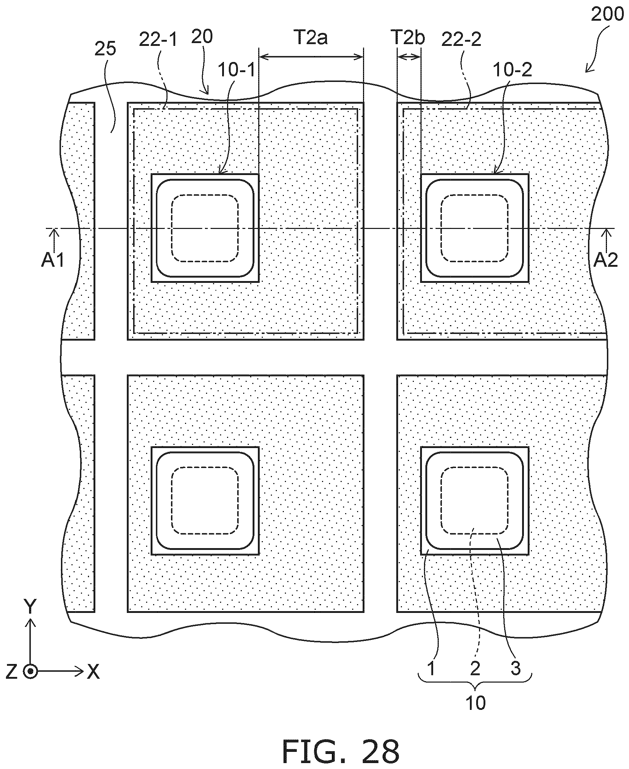

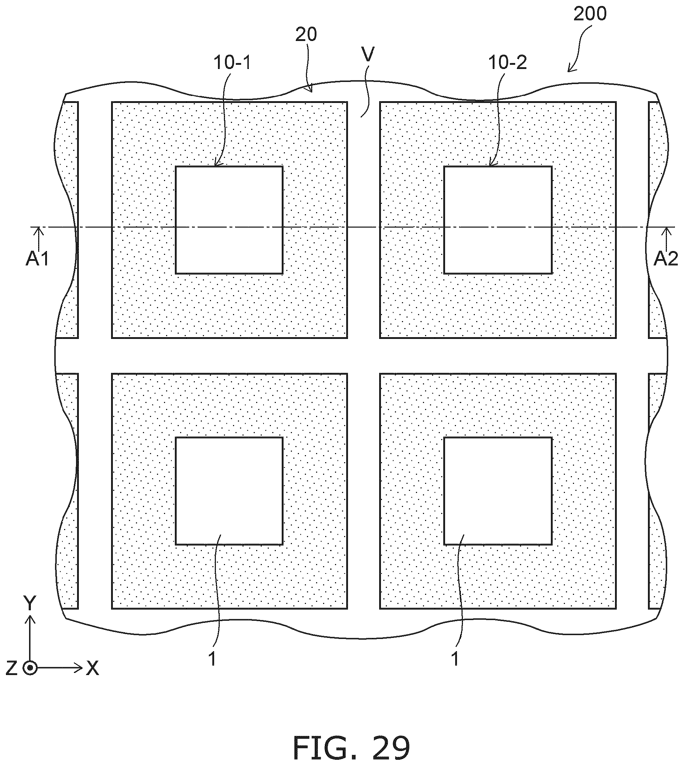

In FIG. 27, the insulating layers 33 to 36 are not illustrated, and the second semiconductor regions 2 are illustrated by broken lines. FIG. 28 corresponds to a B1-B2 cross-sectional view of FIG. 30. FIG. 29 corresponds to a C1-C2 cross-sectional view of FIG. 30.

In the light detector 200 according to the second embodiment as shown in FIGS. 27 to 29, one structure body 20 is provided around the elements 10 in the X-Y plane.

Similarly to the light detector 100, the structure body 20 includes the first insulating portion 21, the second insulating portion 22, and the metal-including portion 25. As shown in FIG. 29, one first insulating portion 21 is provided around the elements 10 in the X-Y plane. As shown in FIG. 28, one metal-including portion 25 is provided around the elements 10 in the X-Y plane.

For example, as shown in FIGS. 28 and 30, one second insulating portion 22 is provided between the metal-including portion 25 and one element 10. The multiple second insulating portions 22 are provided respectively around the multiple elements 10 in the X-Y plane. In the light detector 200 as well, the thickness in the Z-direction of the first insulating portion 21 is greater than the thickness of the second insulating portion 22 between the element 10 and the metal-including portion 25.

As one specific example, the multiple elements 10 include elements 10-1 and 10-2 as shown in FIGS. 28 to 30. The element 10-2 is adjacent to the element 10-1 in the X-direction. The structure body 20 includes second insulating portions 22-1 and 22-2. The second insulating portion 22-1 is provided around the element 10-1 in the X-Y plane. The second insulating portion 22-2 is provided around the element 10-2 in the X-Y plane.

A portion of the second insulating portion 22-1 and a portion of the second insulating portion 22-2 are positioned between the elements 10-1 and 10-2. The thickness T1 (shown in FIG. 30) in the Z-direction of the first insulating portion 21 is greater than a thickness T2a (shown in FIGS. 28 and 30) in the X-Y plane of the portion of the second insulating portion 22-1 between the element 10-1 and the metal-including portion 25 in a direction connecting the elements 10-1 and 10-2. The thickness T1 of the first insulating portion 21 is greater than a thickness T2b in the X-Y plane of the portion of the second insulating portion 22-2 between the element 10-2 and the metal-including portion 25 in the direction connecting the elements 10-1 and 10-2.

As shown in FIGS. 29 and 30, the structure body 20 may include a void V. For example, the void V is provided in the first insulating portion 21. A portion of the void V may be provided in the second insulating portion 22. The void V is separated from the metal-including portion 25. For example, as shown in FIG. 29, one continuous void V may be provided around the elements 10 in the X-Y plane.

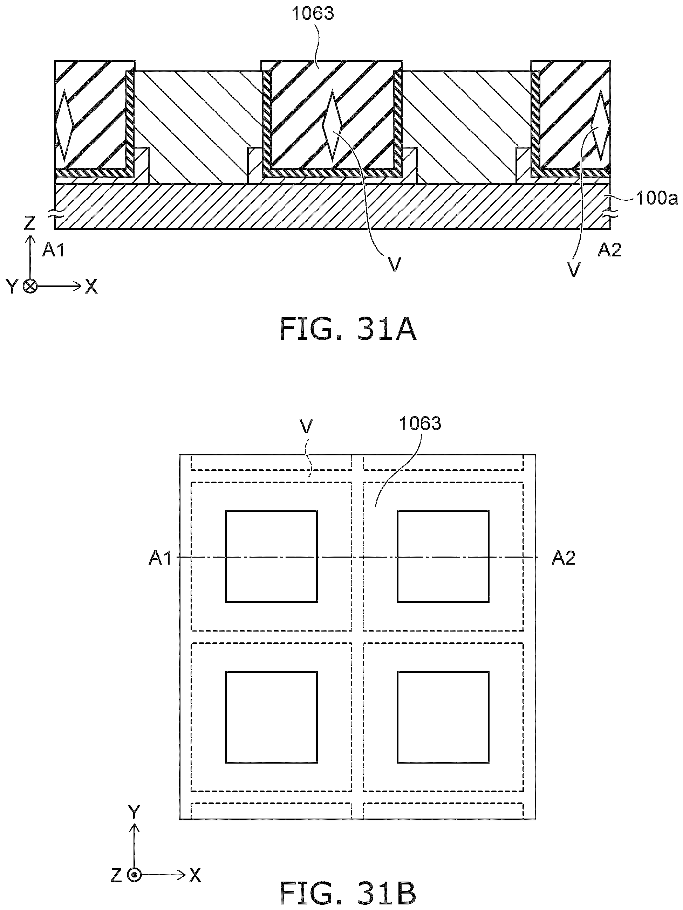

FIGS. 31A to 35B are schematic views illustrating manufacturing processes of the light detector according to the second embodiment.

FIGS. 31A to 35A respectively show A1-A2 cross sections of FIGS. 31B to 35B. An example of the manufacturing processes of the light detector according to the second embodiment will be described with reference to FIGS. 31A to 35B.

First, processes similar to the processes shown in FIGS. 5A to 9B are performed. In the process shown in FIGS. 7A and 7B, the first trench 106 that corresponds to the position and the shape of the structure body 20 of the light detector 200 is formed. In the process shown in FIGS. 9A and 9B, the oxide film 1063 may be formed so that the void V exists along the X-direction and the Y-direction. As shown in FIGS. 31A and 31B, the oxide film 1063 that includes the void V is formed thereby. The width of the oxide film 1063 is, for example, 2.5 µm.

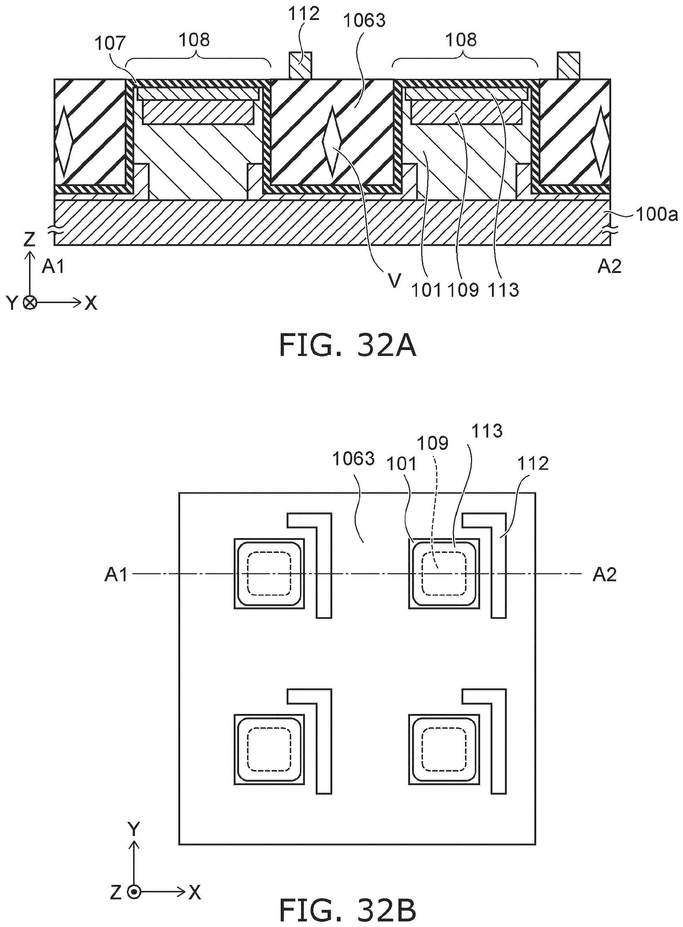

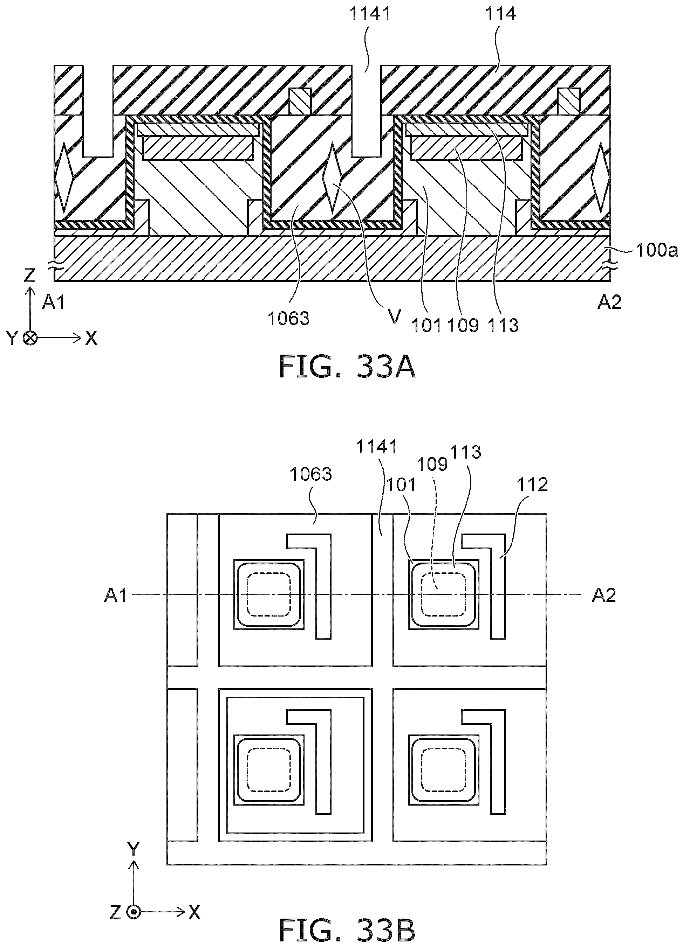

The silicon oxide film 107, the quenching resistance 112, the p-type avalanche layer 109, and the n-type avalanche layer 113 are formed as shown in FIGS. 32A and 32B. For example, the silicon oxide film 107, the quenching resistance 112, the p-type avalanche layer 109, and the n-type avalanche layer 113 are formed by processes similar to the processes shown in FIGS. 11A to 13B. The silicon oxide film 107 is not illustrated in FIGS. 33B to 35B.

The insulating film 114 and the second trench 1141 are formed as shown in FIGS. 33A and 33B. The insulating film 114 is not illustrated in FIGS. 33B, 34B, and 35B. For example, the insulating film 114 and the second trench 1141 are formed by a process similar to the process shown in FIGS. 14A and 14B. For example, the width of the second trench 1141 is 0.6 µm. The depth of the second trench 1141 from the silicon epitaxial layer 101 upper surface is 3 µm. The second trench 1141 is formed not to communicate with the void V. For example, the second trench 1141 is formed to avoid the void V as a position shifted 0.35 µm from the center between the adjacent n-type avalanche layers 113.

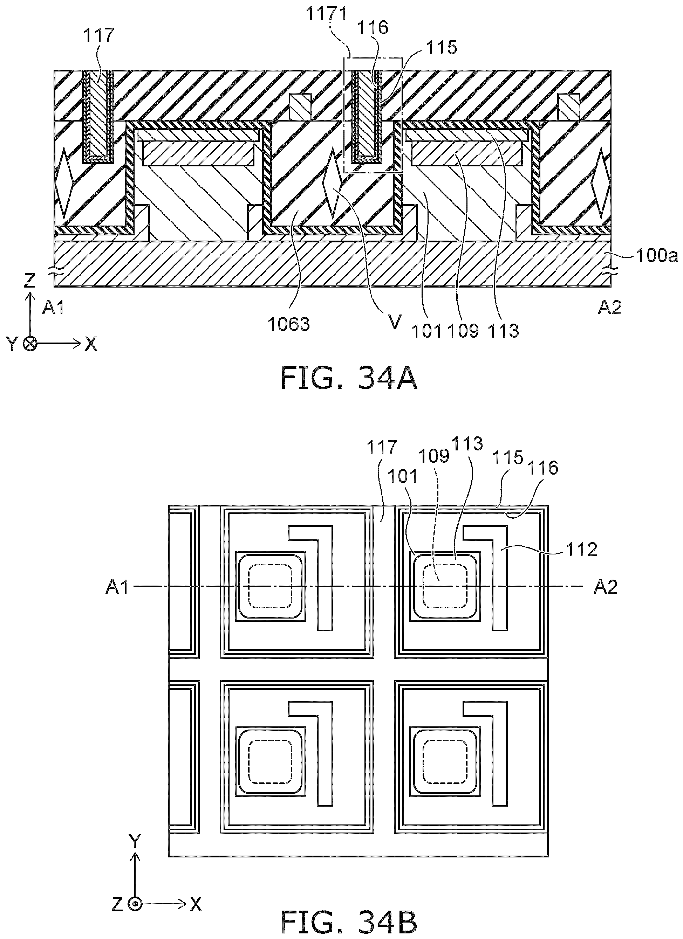

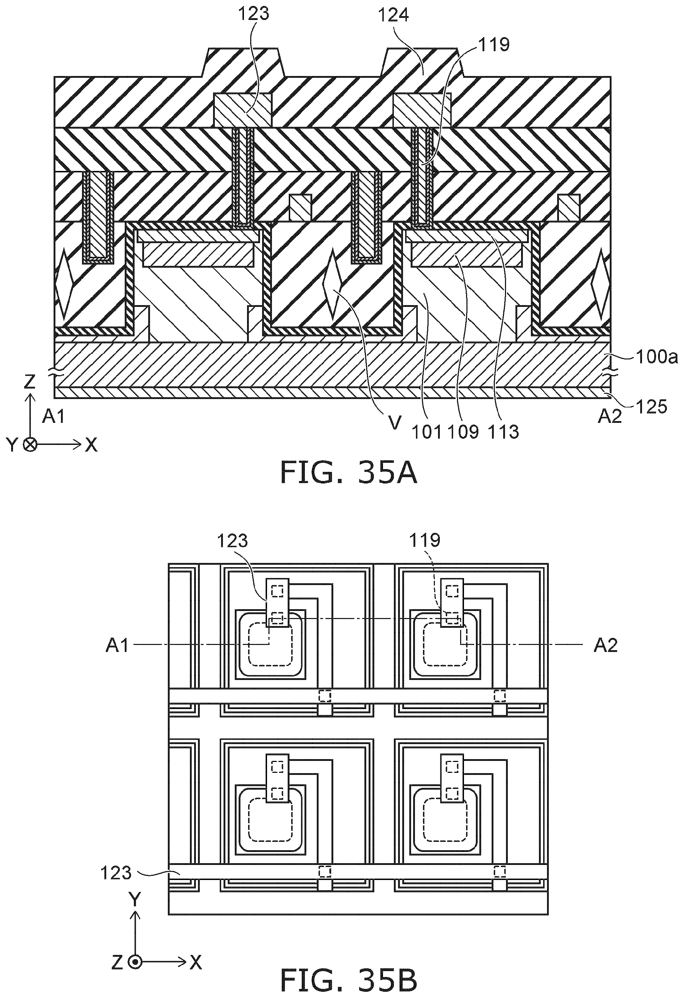

The titanium film 115, the titanium nitride film 116, and the tungsten film 117 are formed as shown in FIGS. 34A and 34B. Subsequently, processes similar to those of FIGS. 16A to 19 are performed. As shown in FIGS. 35A and 35B, the light detector 200 according to the second embodiment is manufactured thereby.

Effects of the second embodiment will now be described.

In the light detector 200 according to the second embodiment, the thickness T1 of the first insulating portion 21 is greater than the thickness T2a or T2b of the second insulating portion 22. Therefore, according to the second embodiment, similarly to the first embodiment, the sensitivity of the light detector 200 can be increased while suppressing the increase of the crosstalk noise of the light detector 200.

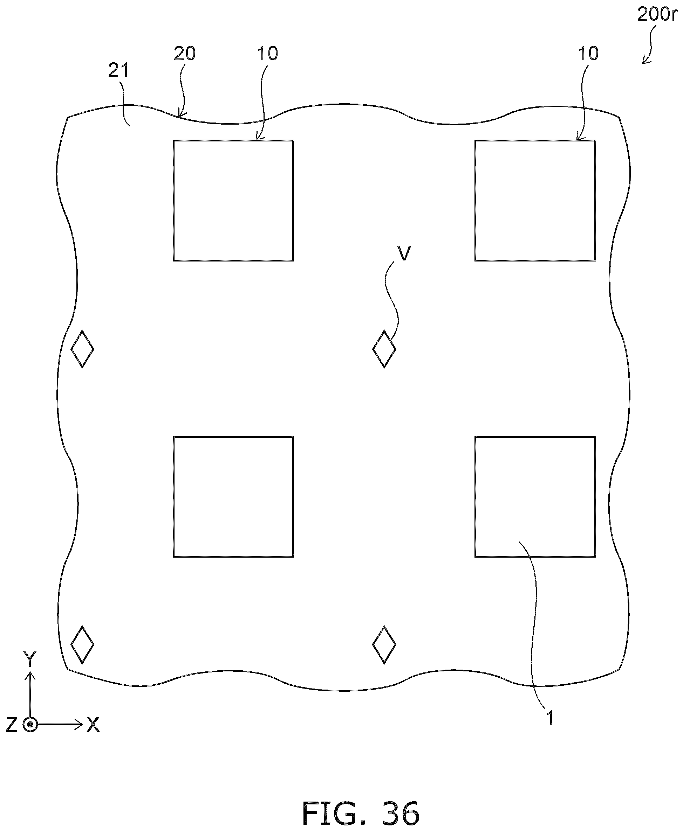

FIG. 36 is a schematic plan view illustrating a portion of a light detector according to a reference example.

FIG. 36 shows a cross section of the light detector 200r according to the reference example. The cross section is perpendicular to the Z-direction and passes through the first insulating portion 21. Multiple voids V are interspersed in the light detector 200r. Each void V is positioned between the elements 10 adjacent to each other in an oblique direction. The voids V do not exist between the elements 10 adjacent to each other in the X-direction and between the elements 10 adjacent to each other in the Y-direction. When the multiple voids V are interspersed as in the light detector 200r, stress concentration occurs at the upper end vicinities of the voids V. Thereby, cracks easily occur from the voids V as starting points.

For this problem, in the light detector 200, one void V is continuous between the adjacent elements 10. For example, one continuous void V is provided around the elements 10. By continuously providing the void V, the stress that is generated at the upper end vicinity of the void V can be dispersed. The occurrence of cracks having the void V as a starting point can be suppressed thereby. Also, the void V may deform according to the stress generated in the structure body 20 and/or the element 10. Therefore, the stress that is generated in the structure body 20 and/or the element 10 is relaxed. The occurrence of cracks in portions other than the void V also can be suppressed thereby.

Favorable shapes of the structure body 20 for forming the continuous void V will now be described.

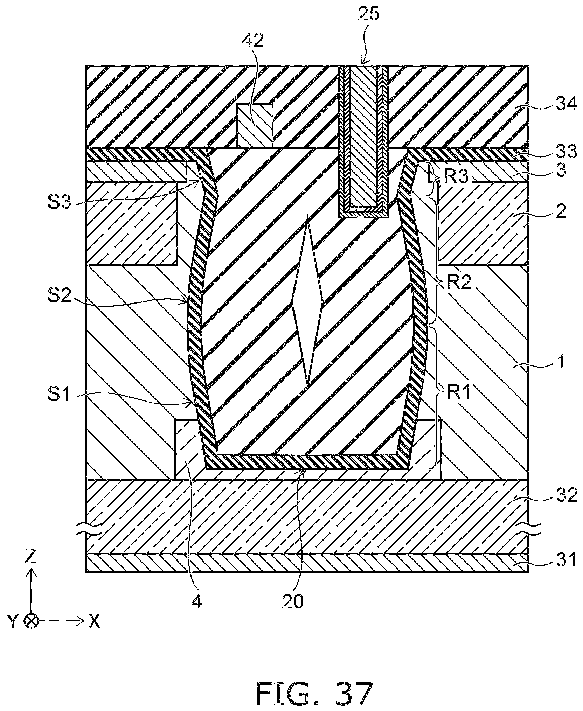

FIG. 37 is a schematic cross-sectional view illustrating a portion of the light detector according to the second embodiment.

As shown in FIG. 37, it is favorable for the structure body 20 to include a first region R1 and a second region R2. The second region R2 is provided on the first region R1. The width of the first region R1 is wider upward. The width of the second region R2 is narrower upward. A side surface S1 of the first region R1 and a side surface S2 of the second region R2 are oblique to the Z-direction. The widths correspond to lengths in a direction that is perpendicular to the Z-direction and the direction in which the structure body 20 extends. In FIG. 37, a portion of the structure body 20 extending along the Y-direction is shown. The width corresponds to the length in the X-direction of the portion of the structure body 20. Similarly, the width of a portion of the structure body 20 extending along the X-direction corresponds to the length in the Y-direction of the portion of the structure body 20.

The structure body 20 may further include a third region R3. The third region R3 is provided on the second region R2. The width of the third region R3 is wider upward. A side surface S3 of the third region R3 is oblique to the Z-direction.

For example, the boundary between the second region R2 and the third region R3 is provided at the same height as the metal-including portion 25 and the second insulating portion 22. The boundary between the second region R2 and the third region R3 may be positioned lower than the metal-including portion 25 and the second insulating portion 22.

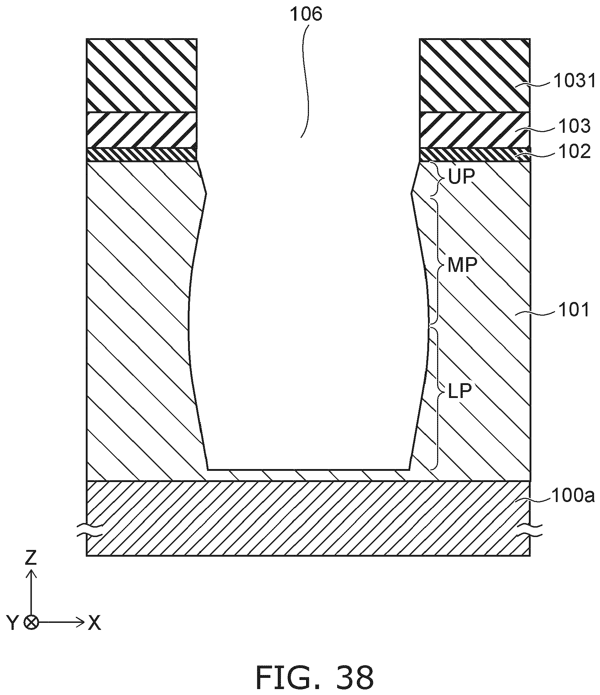

FIG. 38 is a schematic view illustrating manufacturing processes of the light detector according to the second embodiment.

For example, to make the structure body 20 shown in FIG. 37, the first trench 106 that corresponds to the shape of the structure body 20 is formed in the process shown in FIGS. 7A and 7B. Specifically, as shown in FIG. 38, the width of a lower portion LP of the first trench 106 is wider upward. The width of a middle portion MP of the first trench 106 is narrower upward. The width of an upper portion UP of the first trench 106 is wider upward. The side surface S1 of the lower portion LP, the side surface S2 of the middle portion MP, and the side surface S3 of the upper portion UP are oblique to the Z-direction.

For example, the flow rate and the pressure of the reactive gas in the RIE process are changed when forming the first trench 106. By changing the flow rate and the pressure of the reactive gas, the anisotropy of the etching of the silicon epitaxial layer 101 is changed. The first trench 106 that has the shape shown in FIG. 38 can be formed thereby. The continuous void V is easily formed inside the oxide film 1063 by forming the oxide film 1063 inside the first trench 106 having the shape shown in FIG. 38.

The pressure of the void V may be equal to atmospheric pressure or less than atmospheric pressure. Air may exist in the void V, and an inert gas may exist in the void V. For example, the concentration of the inert gas in the void V may be greater than the concentration of the inert gas in ambient air. The inert gas is, for example, at least one selected from the group consisting of helium, neon, argon, and nitrogen.

In the light detector 200, it is favorable for the third semiconductor region 3 to be separated from the structure body 20. If the third semiconductor region 3 contacts the structure body 20, defects increase in the region where the outer perimeter of the third semiconductor region 3 is formed when forming the first trench 106 for providing the structure body 20. The increase of the defects increases the effects of an afterpulse that is output after the pulse due to the incident light. When the third semiconductor region 3 is separated from the structure body 20, the number of defects in the third semiconductor region 3 can be reduced, and the effects of the afterpulse caused by the defects can be suppressed.

For example, it is favorable for the distance between the third semiconductor region 3 and the structure body 20 to be 0.5 µm or more. However, the surface area in the X-Y plane of the third semiconductor region 3 becomes small if the distance is too long. Therefore, it is favorable for the distance to be 1.0 µm or less.

As shown in FIG. 30, it is favorable for a lower end LE of the outer perimeter of the third semiconductor region 3 to contact a portion of the first semiconductor region 1. For example, the length in the X-direction or the Y-direction of the second semiconductor region 2 is less than the length in the X-direction or the Y-direction of the third semiconductor region 3. A portion of the first semiconductor region 1 is arranged with the second semiconductor region 2 in the X-direction or the Y-direction and contacts the lower end LE of the third semiconductor region 3. The p-n junction is formed between the first semiconductor region 1 and the lower end LE.

When the lower end LE contacts the first semiconductor region 1, the electric field intensity at the lower end LE vicinity can be reduced. The occurrence of local breakdown at the lower end LE vicinity can be suppressed, and the breakdown voltage of the element 10 can be increased.

As shown in FIG. 27, it is favorable for a corner portion C in the X-Y plane of the third semiconductor region 3 to be curved when viewed from the Z-direction. Favorably, the curvature radius of the corner portion C is not less than 1 µm and not more than 7 µm. Because the corner portion C is curved, the electric field intensity at the corner portion C vicinity can be reduced.

Similarly to the light detector 200, the third semiconductor region 3 may be separated from the structure body 20 in the light detectors according to the other embodiments. The corner portions of the third semiconductor region 3 may be curved. The lower end LE of the third semiconductor region 3 may contact the first semiconductor region 1.

### Third embodiment

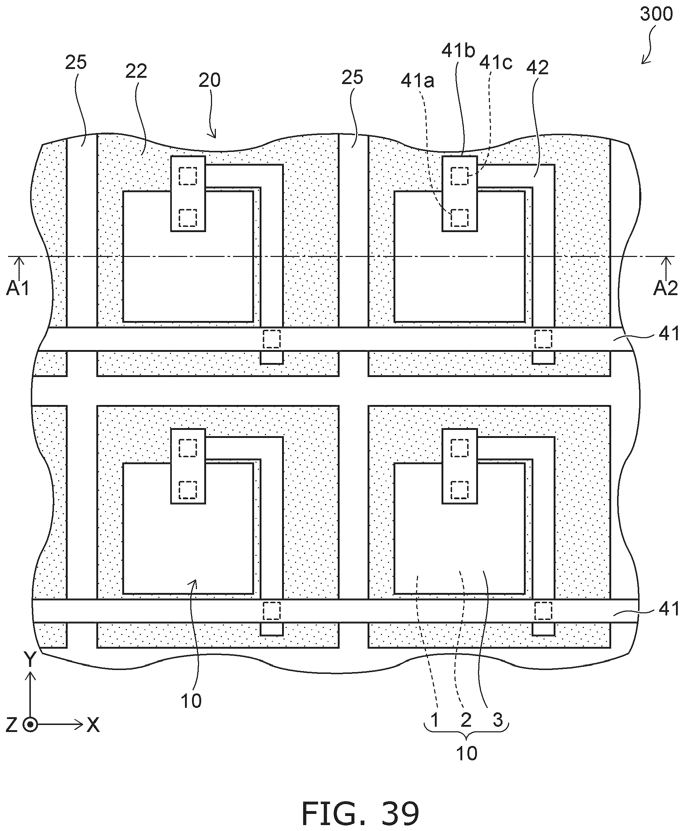

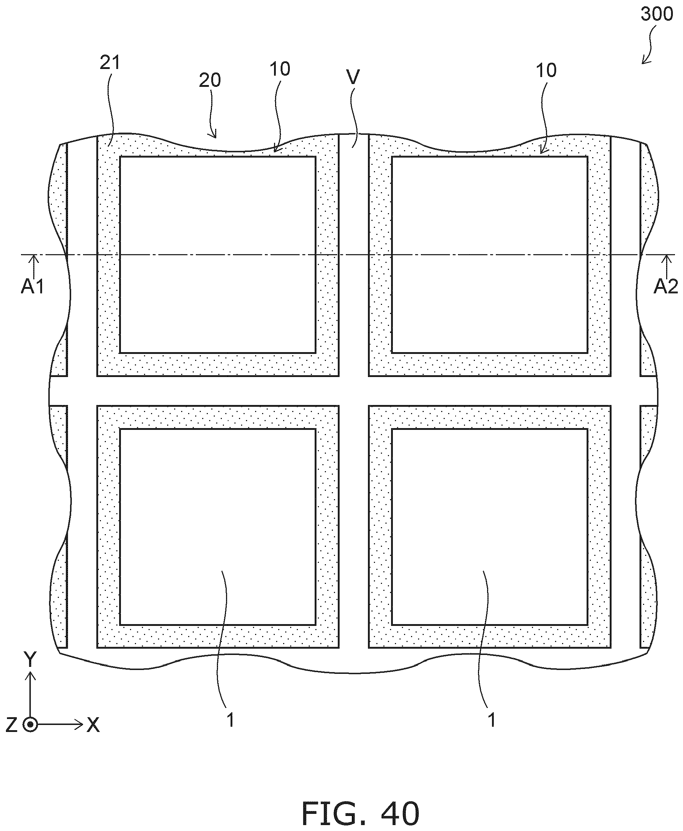

FIGS. 39 and 40 are schematic plan views illustrating a portion of a light detector according to a third embodiment.

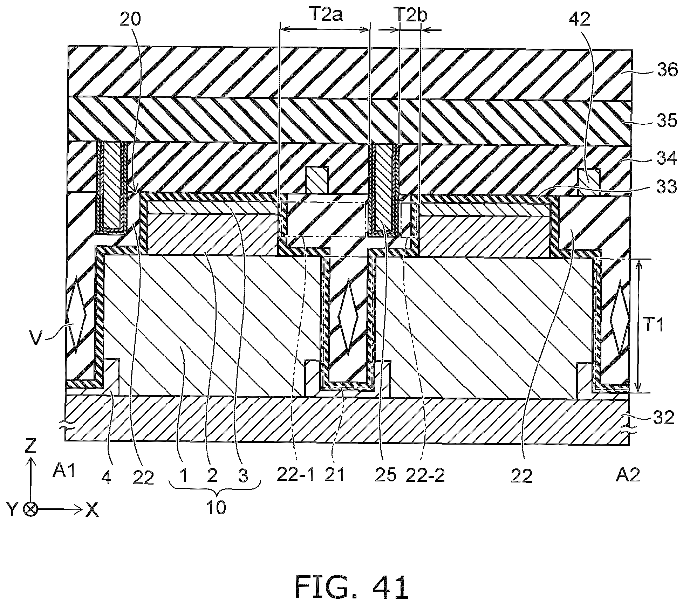

FIG. 41 is an A1-A2 cross-sectional view of FIGS. 39 and 40.

The insulating layers 33 to 36 are not illustrated in FIG. 39. FIG. 40 corresponds to a B1-B2 cross-sectional view of FIG. 41.

The shape of the structure body 20 of the light detector 300 according to the third embodiment is different from that of the light detector 200 according to the second embodiment.

In the light detector 300 as shown in FIG. 41, the width of the lower portion of the structure body 20 is less than the width of the upper portion of the structure body 20. Specifically, the width of the first insulating portion 21 is less than the sum of the width of the second insulating portion 22 and the width of the metal-including portion 25. For example, the width of the first insulating portion 21 is less than the width of the second insulating portion 22.

The widths correspond to lengths in a direction perpendicular to the Z-direction and the direction in which the structure body 20 extends. FIG. 37 shows a portion of the structure body 20 extending along the Y-direction. The width corresponds to the length in the X-direction of the portion of the structure body 20. In other words, in FIG. 41, the width of the first insulating portion 21 corresponds to the length in the X-direction of the first insulating portion 21. The width of the second insulating portion 22 corresponds to the length in the X-direction of the second insulating portion 22. Similarly, the width of a portion of the structure body 20 extending along the X-direction corresponds to the length in the Y-direction of the portion of the structure body 20.

The metal-including portion 25 may be positioned directly above the first insulating portion 21 or may not be positioned directly above the first insulating portion 21. It is sufficient for the metal-including portion 25 to exist higher than the first insulating portion 21. For example, the metal-including portion 25 may be arranged in the Z-direction with a portion of the first semiconductor region 1.

The void V may be provided in the first insulating portion 21. The void V is positioned lower than the second insulating portion 22 and the metal-including portion 25. For example, as shown in FIG. 40, one void V is provided around the elements 10 in the X-Y plane.

An example of manufacturing processes of the light detector according to the third embodiment will now be described.

First, the first trench 106 is formed by performing processes similar to the processes shown in FIGS. 4 to 7B. One first trench 106 is formed in a lattice configuration in the X-direction and the Y-direction in the process shown in FIGS. 7A and 7B. At this time, the width of the first trench 106 corresponds to the width of the first insulating portion 21. The silicon oxide film 1061 and the oxide film 1063 are formed inside the first trench 106.

The upper portion of a separation region made of the silicon oxide film 1061 and the oxide film 1063 and the silicon epitaxial layer 101 adjacent to the upper portion of the separation region are removed by a lithography process and an RIE process. Thereby, a wider opening is formed on the remaining silicon oxide film 1061 and oxide film 1063. A silicon oxide film is formed along the inner wall of the opening. The opening is filled with a buried oxide film. Thereafter, processes similar to the processes shown in FIGS. 33A to 36 are performed. By the processes described above, the light detector 300 according to the third embodiment is manufactured.

In the manufacturing processes described above, the width of the first trench 106 may be reduced, and the aspect ratio of the first trench 106 may be increased. Thereby, it is difficult to completely fill the first trench 106 with the oxide film 1063. As a result, the continuous void V is formed inside the oxide film 1063. For example, as shown in FIG. 40, the void V that has a lattice configuration extending along the X-direction and the Y-direction can be formed.

Or, similarly to the first trench 106 shown in FIG. 38, the width of the bottom portion of the first trench 106 may change in the Z-direction. The void V is continuously formed more easily thereby.

Effects of the third embodiment will now be described.

In the light detector 300 according to the third embodiment, the thickness T1 of the first insulating portion 21 is greater than the thickness T2a or T2b of the second insulating portion 22. Therefore, according to the third embodiment, similarly to the first embodiment, the sensitivity of the light detector 300 can be increased while suppressing the increase of the crosstalk noise of the light detector 300.

In the light detector 300, the void V exists in the first insulating portion 21. Similarly to the light detector 200, the stress that is generated in the structure body 20 and/or the element 10 can be relaxed by the void V. By providing the continuous void V, the occurrence of cracks having the void V as a starting point can be suppressed.

When the structure body 20 includes the void V, the metal-including portion 25 is separated from the void V. For example, as shown in FIGS. 33A and 33B, the second trench 1141 for forming the metal-including portion 25 is formed not to communicate with the void V. To form the second trench 1141 not to communicate with the void V, it is necessary for the position in the X-Y plane of the second trench 1141 to be shifted from the position in the X-Y plane of the void V. As a result, the length in the X-direction or the Y-direction of the structure body 20 is increased compared to when the void V is not included.

For this problem, in the light detector 300, the first insulating portion 21 is provided below the second insulating portion 22 and the metal-including portion 25. The width of the first insulating portion 21 is less than the sum of the width of the second insulating portion 22 and the width of the metal-including portion 25. The void V is provided inside the first insulating portion 21 and is separated from the metal-including portion 25 in the Z-direction.

According to this structure, compared to the light detector 200, the void V is positioned lower in the structure body 20. When forming the second trench 1141 for the metal-including portion 25, the void V exists lower than the second trench 1141. It is unnecessary for the position in the X-Y plane of the second trench 1141 to be shifted from the position in the X-Y plane of the void V. Therefore, compared to the light detector 200, the width of the structure body 20 can be narrow. As a result, for example, the surface area in the X-Y plane of the second and third semiconductor regions 2 and 3 can be increased, and the sensitivity of the light detector 300 can be increased. Or, the light detector 300 can be downsized by the amount of the reduction of the surface area of the structure body 20.

In the example described herein, a narrower first insulating portion 21 is provided to separate the metal-including portion 25 from the void V. The structure is not limited to the example; the structure of the structure body 20 according to the third embodiment is applicable even when another member is provided in the structure body 20. In other words, the width of the lower portion of the structure body 20 may be less than the width of the upper portion of the structure body 20, and the void V may be provided in the lower portion of the structure body 20. Thereby, even when some member is provided in the upper portion of the structure body 20, the increase of the width of the structure body 20 can be suppressed.

### Modification

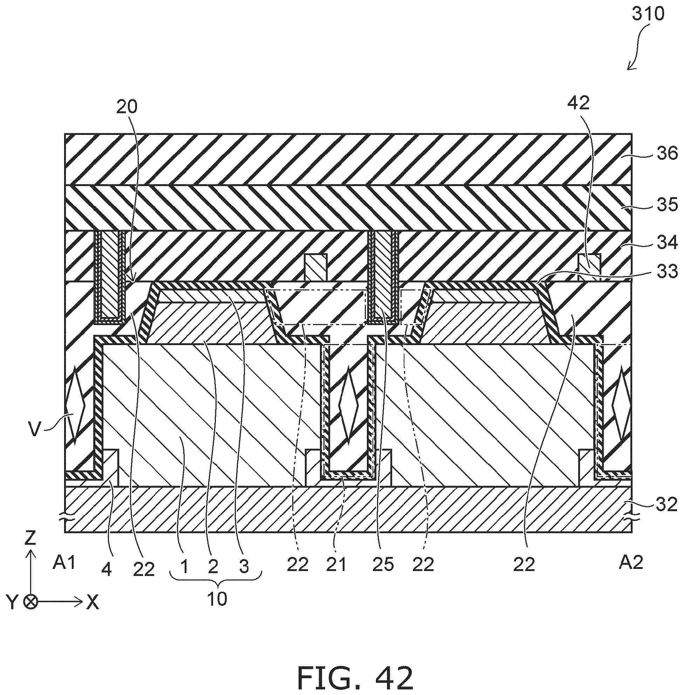

FIG. 42 is a schematic cross-sectional view illustrating a portion of a light detector according to a modification of the third embodiment.

In the light detector 310 shown in FIG. 42, the side surface of the upper portion of the structure body 20 is oblique to the Z-direction. Specifically, the surface of the structure body 20 positioned between the element 10 and the metal-including portion 25 is oblique to the Z-direction. The thickness of the second insulating portion 22 between the element 10 and the metal-including portion 25 is narrower downward.

Due to the obliqueness of the side surface of the upper portion of the structure body 20, the secondary photons that are generated at the p-n junction surface of the element 10 are easily reflected. The crosstalk noise of the light detector 310 is further reduced thereby.

It is favorable for the tilt angle with respect to the Z-direction of the side surface of the upper portion of the structure body 20 to be 21 degrees or more so that the secondary photons is easily reflected.

### Example

The following verification was performed for the embodiments described above.

First, a negative bias was applied to the electrode 31 as an operating voltage in the light detector 200 according to the second embodiment. The avalanche pulse signal that was output from the pad 43 was read in a state in which light was not incident on the element 10. The measurement was performed for a pulse count of 10000 or more, and a histogram in which the horizontal axis is the number of photoelectric electrons per pulse was made using the gain of the element 10 and the conversion coefficient of the measurement system. In the histogram, (the count necessary for the number of photoelectric electrons to become 2 or more)/(the total count) was calculated as the direct crosstalk probability (PDi-CTK).

To calculate the delayed crosstalk probability, a delayed pulse count histogram (a time correlation histogram) was made for the pulse count measurement, in which the horizontal axis was the time difference from any pulse output trigger to the next generated pulse. The time correlation histogram was separated into multiple delayed pulse distributions, and the pulse counts included in the distributions were calculated. Then, for each delay time, the delayed crosstalk probability (PDe-CTK) was calculated using the definition of (the count included in the delayed pulse distribution)/(the total count).

Based on the technique described above, an evaluation of the light detector 200 according to the second embodiment was performed, and the following results were obtained.

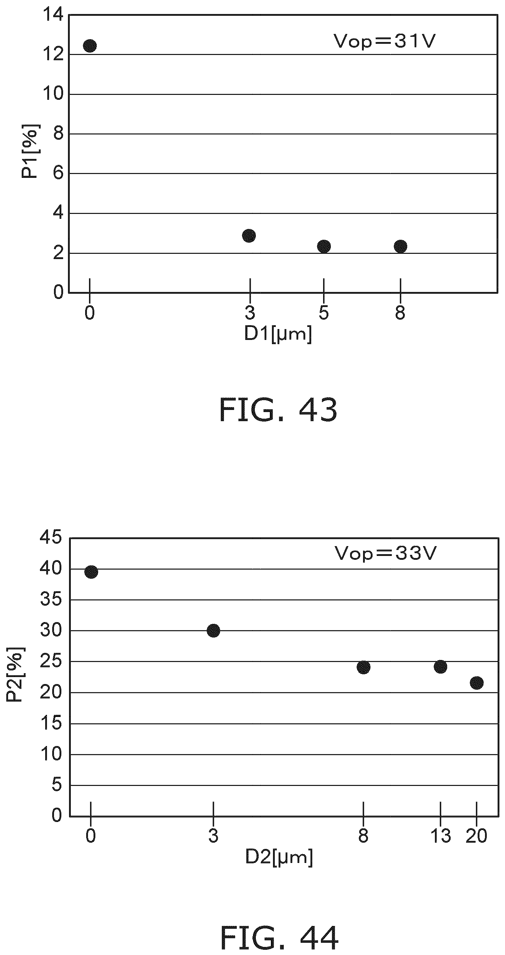

FIGS. 43 and 44 are graphs illustrating characteristics of the light detector according to the embodiment.

In FIG. 43, the horizontal axis is a depth D1 of the metal-including portion 25 from the upper surface of the element 10. The depth corresponds to the length in the Z-direction. Here, the depth of the structure body 20 from the upper surface of the element 10 is 9.0 µm. The thickness in the Z-direction of the third semiconductor region 3 is 0.5 µm. The vertical axis is a direct crosstalk probability P1. In FIG. 43, the point at which the depth D1 is 0 µm is the characteristic when the structure body 20 is not provided. From the results of FIG. 43, it can be seen that compared to when the structure body 20 is not provided, the direct crosstalk probability P1 is greatly reduced by providing the structure body 20 including the metal-including portion 25.

The probability P1 was substantially constant when the depth D1 was 3 µm or more. In the verification relating to FIG. 43, an operating voltage Vop was -31 V. In such a case, the depletion layer extended from the upper surface of the element 10 to a depth of 3 µm. From the results described above, it can be seen that it is favorable for the depth of the metal-including portion 25 to be not less than the depletion layer depth.

In FIG. 44, the horizontal axis is a depth D2 of the structure body 20 from the upper surface of the element 10. The vertical axis is a delayed crosstalk probability P2. In FIG. 44, the point at which the depth D2 is 0 µm is the characteristic when the structure body 20 is not provided. From the results of FIG. 44, it can be seen that the delayed crosstalk probability P2 is reduced at least 10% when the structure body 20 is provided.

On the other hand, the probability P2 was substantially constant when the depth D2 was 8 µm or more. In the verification relating to FIG. 44, the depth from the upper surface of the element 10 to the conductive layer 32 was 10 µm. From the results described above, it can be seen that it is favorable for the depth of the structure body 20 to be equal to or greater than the depth from the upper surface of the element 10 to the conductive layer 32.

Also, from the results of FIGS. 43 and 44, it can be seen that the depth of the metal-including portion 25 may be less than the depth of the structure body 20 to reduce the direct crosstalk probability P1.

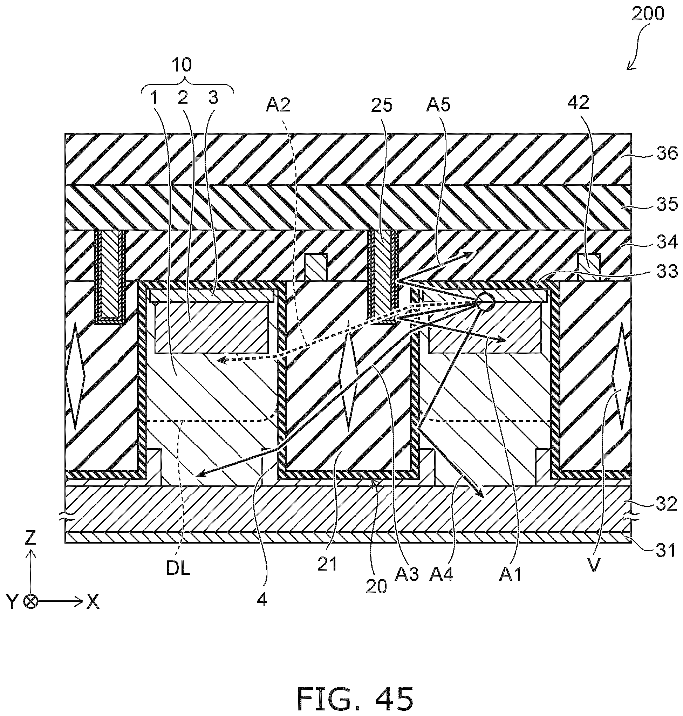

FIG. 45 is a schematic cross-sectional view illustrating a portion of the light detector according to the second embodiment.

Secondary photons radiate isotropically from an avalanche origin point at the p-n junction surface vicinity. At this time, as shown by arrow A1 of FIG. 45, the secondary photons that are radiated toward the adjacent element 10 are reflected by the metal-including portion 25. Or, these secondary photons are absorbed by the metal-including portion 25. When the metal-including portion 25 is not provided, the secondary photons may enter the adjacent element 10 as shown in arrow A2. By providing the metal-including portion 25, the penetration of the secondary photons into the adjacent elements 10 can be suppressed.

As shown by arrows A3 and A4, the light that travels below the metal-including portion 25 is refracted or reflected by the first insulating portion 21. For example, the light that travels through the first insulating portion 21 is refracted and passes through lower than a depletion layer DL of the adjacent element 10. Therefore, the direct crosstalk that occurs due to the secondary photons undergoing photoelectric conversion in the depletion layer DL is suppressed. The secondary photons that pass below the depletion layer DL enter the conductive layer 32. The carriers that are generated by photoelectric conversion of the secondary photons disappear due to recombination in the conductive layer 32. The delayed crosstalk that occurs due to the diffusion of the carriers undergoing photoelectric conversion outside the depletion layer DL is suppressed thereby.

When the void V exists in the first insulating portion 21, the secondary photons are reflected also at the interface between the void V and the first insulating portion 21. The crosstalk is further reduced thereby.

A portion of the secondary photons radiated upward from the p-n junction surface are reflected by the metal-including portion 25 as shown by arrow A5. Or, this portion of the secondary photons is absorbed by the metal-including portion 25. From verifications by the inventors, it was found that the reflection or the absorption of the secondary photons higher than the element 10 also contributes to the reduction of the crosstalk noise.

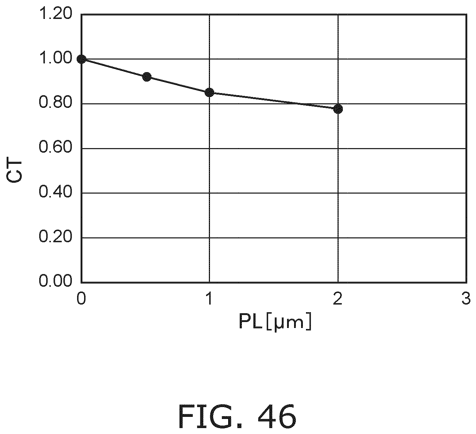

FIG. 46 is a graph illustrating a characteristic of the light detector according to the second embodiment.

In FIG. 46, the horizontal axis is a protruding length PL of the metal-including portion 25 from the upper surface of the element 10. In other words, the length PL is the distance in the Z-direction between the upper surface of the element 10 and the upper end of the metal-including portion 25. The vertical axis is a relative crosstalk amount CT at each length PL, in which the crosstalk amount is taken to be 1 when the length PL is 0 µm.

From FIG. 46, it can be seen that when the length PL is 2 µm or less, the relative crosstalk amount CT decreases as the length PL increases. On the other hand, the verifications by the inventors show that the relative crosstalk amount CT is substantially constant when the length PL is greater than 2 µm. The formation of the metal-including portion 25 becomes difficult as the length PL increases. Based on these results, it is favorable for the length PL to be not less than 1 µm and not more than 2 µm.

### Fourth embodiment

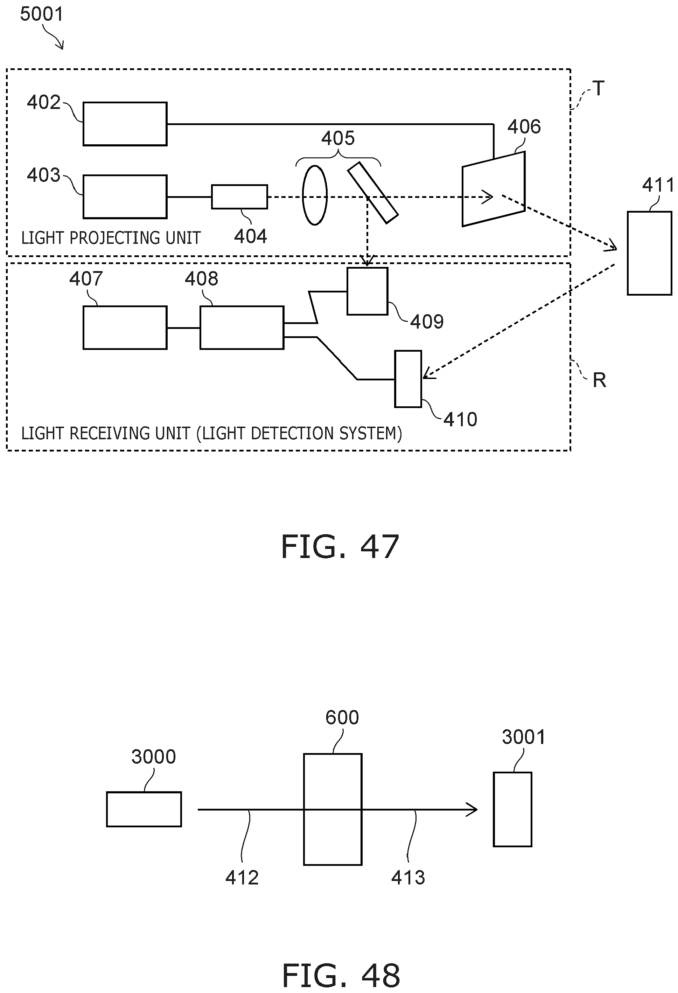

FIG. 47 is a schematic view illustrating a lidar (Laser Imaging Detection and Ranging (LIDAR)) device according to a fourth embodiment.

The embodiment is applicable to a long-distance subject detection system (LIDAR) or the like including a line light source and a lens. The lidar device 5001 includes a light projecting unit T projecting laser light toward an object 411, and a light receiving unit R (also called a light detection system) receiving the laser light from the object 411, measuring the time of the round trip of the laser light to and from the object 411, and converting the time into a distance.

In the light projecting unit T, a laser light oscillator (also called a light source) 404 produces laser light. A drive circuit 403 drives the laser light oscillator 404. An optical system 405 extracts a portion of the laser light as reference light, and irradiates the rest of the laser light on the object 411 via a mirror 406. A mirror controller 402 projects the laser light onto the object 411 by controlling the mirror 406. Herein, "project" means to cause the light to strike.

In the light receiving unit R, a reference light detector 409 detects the reference light extracted by the optical system 405. A light detector 410 receives the reflected light from the object 411. A distance measuring circuit 408 measures the distance to the object 411 based on the reference light detected by the reference light detector 409 and the reflected light detected by the light detector 410. An image recognition system 407 recognizes the object 411 based on the results measured by the distance measuring circuit 408.

The lidar device 5001 employs light time-of-flight ranging (Time of Flight) in which the time of the round trip of the laser light to and from the object 411 is measured and converted into a distance. The lidar device 5001 is applied to an automotive drive-assist system, remote sensing, etc. Good sensitivity is obtained particularly in the near-infrared region when the light detectors of the embodiments described above are used as the light detector 410. Therefore, the lidar device 5001 is applicable to a light source of a wavelength band invisible to humans. For example, the lidar device 5001 can be used for obstacle detection in a vehicle.

FIG. 48 is a drawing for describing the detection of the detection object of the lidar device.

A light source 3000 emits light 412 toward an object 600 which is the detection object. A light detector 3001 detects light 413 that passes through the object 600, is reflected by the object 600, or is diffused by the object 600.

For example, the light detector 3001 realizes a highly-sensitive detection when the light detector according to the embodiment described above is used. It is favorable to provide multiple sets of the light detector 410 and the light source 404 and to preset the arrangement relationship in the software (which is replaceable with a circuit). For example, it is favorable for the arrangement relationship of the sets of the light detector 410 and the light source 404 to be provided at uniform spacing. Thereby, an accurate three-dimensional image can be generated by the output signals of each light detector 410 complementing each other.

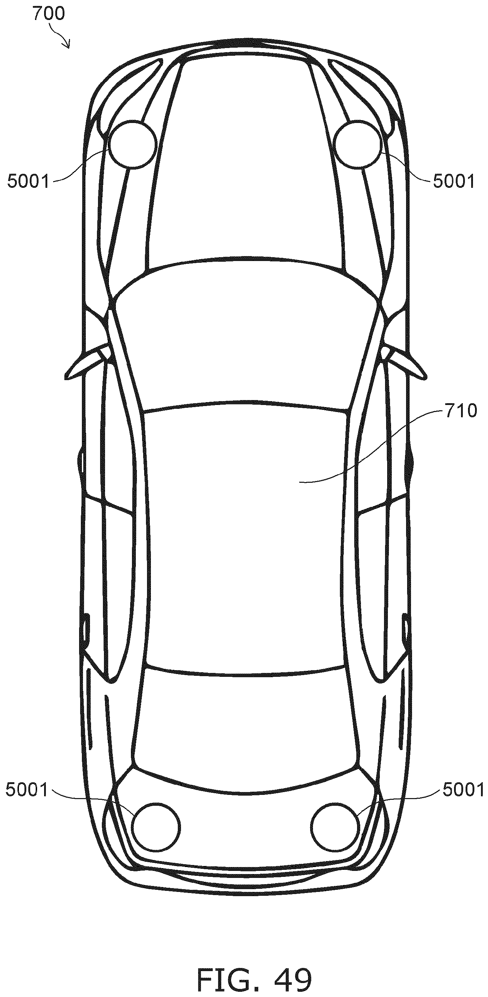

FIG. 49 is a schematic top view of a vehicle including the lidar device according to the fourth embodiment.

The vehicle 700 according to the embodiment includes the lidar devices 5001 at four corners of a vehicle body 710. Because the vehicle according to the embodiment includes the lidar devices at the four corners of the vehicle body, the environment in all directions of the vehicle can be detected by the lidar devices.

In each of the embodiments described above, the relative levels of the impurity concentrations between the semiconductor regions can be confirmed using, for example, a SCM (scanning capacitance microscope). The carrier concentration in each semiconductor region can be considered to be equal to the activated impurity concentration in each semiconductor region. Accordingly, the relative levels of the carrier concentrations between the semiconductor regions also can be confirmed using SCM. The impurity concentration in each semiconductor region also can be measured by, for example, SIMS (secondary ion mass spectrometry).

According to the embodiments described above, the sensitivity of the light detector can be increased while suppressing the increase of the crosstalk noise of the light detector.

In the specification of the application, "perpendicular" and "parallel" refer to not only strictly perpendicular and strictly parallel but also include, for example, the fluctuation due to manufacturing processes, etc. It is sufficient to be substantially perpendicular and substantially parallel.

## Claims

1. A light detector (100, 200, 300), comprising:
an element (10) including
a first semiconductor region (1) of a first conductivity type,
a second semiconductor region (2) provided on the first semiconductor region, the second semiconductor region (2) being of the first conductivity type, an impurity concentration of the first conductivity type in the second semiconductor region (2) being greater than an impurity concentration of the first conductivity type in the first semiconductor region (1), and
a third semiconductor region (3) provided on the second semiconductor region (2), the third semiconductor region (3) contacting the second semiconductor region (2), the third semiconductor region (3) being of a second conductivity type; and
a structure body (20) provided around the element (10) in a first plane perpendicular to a first direction, the first direction being from the first semiconductor region (1) toward the second semiconductor region (2), the structure body (20) including
a first insulating portion (21),
a metal-including portion (25) provided above the first insulating portion (21), a position in the first direction of at least a portion of the metal-including portion (25) being same as a position in the first direction of the third semiconductor region (3), and
a second insulating portion (22) provided above the first insulating portion (21), the second insulating portion (22) being positioned between the metal-including portion (25) and the element (10) in the first plane,
**characterized in that** a distance in the first direction from a bottom surface of the first insulating portion (21) to a boundary surface between the first insulating portion (21) and the metal-including portion (25) is greater than a distance along the first plane from a boundary surface between the element (10) and the second insulating portion (22) to a boundary surface between the second insulating portion (22) and the metal-including portion (25).

2. The light detector (100, 200, 300) according to claim 1, wherein
a position in the first direction of a portion of the metal-including portion (25) is same as a position in the first direction of an interface between the second semiconductor region (2) and the third semiconductor region (3).

3. The light detector (100, 200, 300) according to claim 2, further comprising:
a conductive layer (32),
the element (10) and the structure body (20) being provided on the conductive layer (32),
the structure body (20) being separated from the conductive layer (32).

4. The light detector (100, 200, 300) according to claim 2, further comprising:
a conductive layer (32),
the element (10) and the structure body (20) being provided on the conductive layer (32),
the structure body (20) contacting the conductive layer (32).

5. The light detector (100, 200, 300) according to any one of claims 1 to 4, further comprising:
an interconnect (41) provided above the third semiconductor region (3) and electrically connected to the third semiconductor region (3); and
a quenching part (42) electrically connected between the third semiconductor region (3) and the interconnect (41).

6. The light detector (100, 200, 300) according to claim 5, wherein
an upper end of the metal-including portion (25) is positioned above the third semiconductor region (3) and positioned lower than the interconnect (41).

7. The light detector (200, 300) according to any one of claims 1 to 6, wherein
a void is provided in the first insulating portion (21).

8. The light detector (100, 300) according to any one of claims 1 to 7, wherein
the second semiconductor region (2) and the third semiconductor region (3) contact the structure body (20).

9. The light detector (200) according to any one of claims 1 to 7, wherein
a portion of the third semiconductor region (3) contacts the first semiconductor region (1) in the first direction.

10. The light detector (100, 200, 300) according to any one of claims 1 to 9, wherein
the first insulating portion (21) and the second insulating portion (22) include silicon and one selected from the group consisting of oxygen and nitrogen.

11. The light detector (100, 200, 300) according to any one of claims 1 to 10, wherein
the metal-including portion (25) includes at least one selected from the group consisting of tungsten, aluminum, and copper.

12. The light detector (100, 200, 300) according to any one of claims 1 to 11, wherein
a refractive index of a material included in the first and second insulating portions is less than a refractive index of the semiconductor material included in the element (10), and
the metal-including portion (25) is configured to suppress a penetration of secondary photons from the element (10) into adjacent elements (10) more than the first and second insulating portions, wherein the secondary photons are photons generated at the interface between the second semiconductor region and the third semiconductor region, when light enters the element.

13. The light detector (300), according to any one of claims 1 to 12, wherein the structure body (20) includes
a lower portion including the first insulating portion (21), and
an upper portion including the second insulating portion (22) and the metal-including portion (25), a width of the lower portion being less than a width of the upper portion, a void (V) being provided in the lower portion.

14. The light detector (100, 200, 300) according to any one of claims 1 to 13, wherein
the element (10) includes an avalanche photodiode operating in a Geiger mode.

15. A light detection system (R), comprising:
the light detector (410) according to any one of claims 1 to 14; and
a distance measuring circuit (408) calculating a time-of-flight of light from an output signal of the light detector (410).

16. A lidar device (5001), comprising:
a light source (404) irradiating light onto an object (411); and
the light detection system (R) according to claim 15 detecting light reflected by the object (411).

17. The lidar device (5001) according to claim 16, further comprising:
an image recognition system (407) generating a three-dimensional image based on an arrangement relationship of the light source (404) and the light detector (411).

18. A vehicle (700), comprising:
the lidar device (5001) according to claim 16 or 17.

19. A vehicle (700), comprising:
a vehicle body (710); and
the lidar device (5001) according to claim 16 or 17 at each of four corners of the vehicle body (710).

## Patentansprüche

1. Ein Lichtdetektor (100, 200, 300), umfassend:
ein Element (10), das aufweist:
einen ersten Halbleiterbereich (1) eines ersten Leitfähigkeitstyps,
einen zweiten Halbleiterbereich (2), der auf dem ersten Halbleiterbereich (1) vorgesehen ist, wobei der zweite Halbleiterbereich (2) vom ersten Leitfähigkeitstyp ist und eine Verunreinigungskonzentration des ersten Leitfähigkeitstyps in dem zweiten Halbleiterbereich (2) größer ist als eine Verunreinigungskonzentration des ersten Leitfähigkeitstyps in dem ersten Halbleiterbereich (1), und
einen dritten Halbleiterbereich (3), der auf dem zweiten Halbleiterbereich (2) vorgesehen ist, wobei der dritte Halbleiterbereich (3) den zweiten Halbleiterbereich (2) berührt und von einem zweiten Leitfähigkeitstyp ist; und
einen Strukturkörper (20), der in einer ersten Ebene, die senkrecht zu einer ersten Richtung verläuft, um das Element (10) herum vorgesehen ist, wobei die erste Richtung von dem ersten Halbleiterbereich (1) zu dem zweiten Halbleiterbereich (2) gerichtet ist und der Strukturkörper (20) aufweist:
einen ersten isolierenden Abschnitt (21),
einen metallhaltigen Abschnitt (25), der oberhalb des ersten isolierenden Abschnitts (21) vorgesehen ist, wobei eine Position zumindest eines Teils des metallhaltigen Abschnitts (25) in der ersten Richtung gleich einer Position des dritten Halbleiterbereichs (3) in der ersten Richtung ist, und
einen zweiten isolierenden Abschnitt (22), der oberhalb des ersten isolierenden Abschnitts (21) vorgesehen ist, wobei der zweite isolierende Abschnitt (22) in der ersten Ebene zwischen dem metallhaltigen Abschnitt (25) und dem Element (10) positioniert ist,
**dadurch gekennzeichnet, dass** ein Abstand in der ersten Richtung von einer Unterseite des ersten isolierenden Abschnitts (21) zu einer Grenzfläche zwischen dem ersten isolierenden Abschnitt (21) und dem metallhaltigen Abschnitt (25) größer ist als ein Abstand entlang der ersten Ebene von einer Grenzfläche zwischen dem Element (10) und dem zweiten isolierenden Abschnitt (22) zu einer Grenzfläche zwischen dem zweiten isolierenden Abschnitt (22) und dem metallhaltigen Abschnitt (25).

2. Der Lichtdetektor (100, 200, 300) nach Anspruch 1, wobei
eine Position eines Teils des metallhaltigen Abschnitts (25) in der ersten Richtung gleich einer Position einer Grenzfläche zwischen dem zweiten Halbleiterbereich (2) und dem dritten Halbleiterbereich (3) in der ersten Richtung ist.

3. Der Lichtdetektor (100, 200, 300) nach Anspruch 2, ferner umfassend:
eine leitfähige Schicht (32),
wobei das Element (10) und der Strukturkörper (20) auf der leitfähigen Schicht (32) vorgesehen sind und
der Strukturkörper (20) von der leitfähigen Schicht (32) getrennt ist.

4. Der Lichtdetektor (100, 200, 300) nach Anspruch 2, ferner umfassend:
eine leitfähige Schicht (32),
wobei das Element (10) und der Strukturkörper (20) auf der leitfähigen Schicht (32) vorgesehen sind und
der Strukturkörper (20) die leitfähige Schicht (32) berührt.

5. Der Lichtdetektor (100, 200, 300) nach einem der Ansprüche 1 bis 4, ferner umfassend:
eine Verbindungsleitung (41), die oberhalb des dritten Halbleiterbereichs (3) vorgesehen und elektrisch mit dem dritten Halbleiterbereich (3) verbunden ist; und
ein Löschelement (42), das elektrisch zwischen dem dritten Halbleiterbereich (3) und der Verbindungsleitung (41) angeschlossen ist.

6. Der Lichtdetektor (100, 200, 300) nach Anspruch 5, wobei
ein oberes Ende des metallhaltigen Abschnitts (25) oberhalb des dritten Halbleiterbereichs (3) und unterhalb der Verbindungsleitung (41) positioniert ist.

7. Der Lichtdetektor (200, 300) nach einem der Ansprüche 1 bis 6, wobei
in dem ersten isolierenden Abschnitt (21) ein Hohlraum vorgesehen ist.

8. Der Lichtdetektor (100, 300) nach einem der Ansprüche 1 bis 7, wobei
der zweite Halbleiterbereich (2) und der dritte Halbleiterbereich (3) den Strukturkörper (20) berühren.

9. Der Lichtdetektor (200) nach einem der Ansprüche 1 bis 7, wobei
ein Teil des dritten Halbleiterbereichs (3) den ersten Halbleiterbereich (1) in der ersten Richtung berührt.

10. Der Lichtdetektor (100, 200, 300) nach einem der Ansprüche 1 bis 9, wobei
der erste isolierende Abschnitt (21) und der zweite isolierende Abschnitt (22) Silizium sowie ein aus der aus Sauerstoff und Stickstoff bestehenden Gruppe ausgewähltes Element enthalten.

11. Der Lichtdetektor (100, 200, 300) nach einem der Ansprüche 1 bis 10, wobei
der metallhaltige Abschnitt (25) mindestens ein aus der aus Wolfram, Aluminium und Kupfer bestehenden Gruppe ausgewähltes Element enthält.

12. Der Lichtdetektor (100, 200, 300) nach einem der Ansprüche 1 bis 11, wobei
ein Brechungsindex eines in dem ersten und dem zweiten isolierenden Abschnitt enthaltenen Materials kleiner ist als ein Brechungsindex des in dem Element (10) enthaltenen Halbleitermaterials und
der metallhaltige Abschnitt (25) dazu eingerichtet ist, ein Eindringen von Sekundärphotonen aus dem Element (10) in benachbarte Elemente (10) stärker zu unterdrücken als der erste und der zweite isolierende Abschnitt, wobei die Sekundärphotonen Photonen sind, die an der Grenzfläche zwischen dem zweiten Halbleiterbereich und dem dritten Halbleiterbereich erzeugt werden, wenn Licht in das Element eintritt.

13. Der Lichtdetektor (300) nach einem der Ansprüche 1 bis 12, wobei der Strukturkörper (20) aufweist:
einen unteren Abschnitt, der den ersten isolierenden Abschnitt (21) enthält, und
einen oberen Abschnitt, der den zweiten isolierenden Abschnitt (22) und den metallhaltigen Abschnitt (25) enthält,
wobei eine Breite des unteren Abschnitts kleiner ist als eine Breite des oberen Abschnitts und in dem unteren Abschnitt ein Hohlraum (V) vorgesehen ist.

14. Der Lichtdetektor (100, 200, 300) nach einem der Ansprüche 1 bis 13, wobei
das Element (10) eine im Geiger-Modus arbeitende Lawinenphotodiode aufweist.

15. Ein Lichtdetektionssystem (R), umfassend:
den Lichtdetektor (410) nach einem der Ansprüche 1 bis 14; und
eine Entfernungsmessschaltung (408), die anhand eines Ausgangssignals des Lichtdetektors (410) eine Laufzeit von Licht berechnet.

16. Eine Lidar-Vorrichtung (5001), umfassend:
eine Lichtquelle (404), die ein Objekt (411) mit Licht bestrahlt; und
das Lichtdetektionssystem (R) nach Anspruch 15, das von dem Objekt (411) reflektiertes Licht erfasst.

17. Die Lidar-Vorrichtung (5001) nach Anspruch 16, ferner umfassend:
ein Bilderkennungssystem (407), das auf der Grundlage einer Anordnungsbeziehung zwischen der Lichtquelle (404) und dem Lichtdetektor (411) ein dreidimensionales Bild erzeugt.

18. Ein Fahrzeug (700), umfassend:
die Lidar-Vorrichtung (5001) nach Anspruch 16 oder 17.

19. Ein Fahrzeug (700), umfassend:
eine Fahrzeugkarosserie (710); und
die Lidar-Vorrichtung (5001) nach Anspruch 16 oder 17 an jeder der vier Ecken der Fahrzeugkarosserie (710).

## Revendications

1. Détecteur de lumière (100, 200, 300), comprenant :
un élément (10) comprenant
une première région semi-conductrice (1) d'un premier type de conductivité,
une deuxième région semi-conductrice (2) disposée sur la première région semi-conductrice, la deuxième région semi-conductrice (2) étant du premier type de conductivité, une concentration en impureté du premier type de conductivité dans la deuxième région semi-conductrice (2) étant supérieure à une concentration en impureté du premier type de conductivité dans la première région semi-conductrice (1), et
une troisième région semi-conductrice (3) disposée sur la deuxième région semi-conductrice (2), la troisième région semi-conductrice (3) étant en contact avec la deuxième région semi-conductrice (2), la troisième région semi-conductrice (3) étant d'un deuxième type de conductivité ; et
un corps de structure (20) disposé autour de l'élément (10) dans un premier plan perpendiculaire à une première direction, la première direction s'étendant de la première région semi-conductrice (1) vers la deuxième région semi-conductrice (2), le corps de structure (20) comprenant
une première partie isolante (21),
une partie contenant du métal (25) disposée au-dessus de la première partie isolante (21), une position dans la première direction d'au moins une partie de la partie contenant du métal (25) étant identique à une position dans la première direction de la troisième région semi-conductrice (3), et
une deuxième partie isolante (22) disposée au-dessus de la première partie isolante (21), la deuxième partie isolante (22) étant positionnée entre la partie contenant du métal (25) et l'élément (10) dans le premier plan,
**caractérisé en ce que**
une distance dans la première direction entre une surface inférieure de la première partie isolante (21) et une surface de délimitation entre la première partie isolante (21) et la partie contenant du métal (25) est supérieure à une distance le long du premier plan entre une surface de délimitation entre l'élément (10) et la deuxième partie isolante (22) et une surface de délimitation entre la deuxième partie isolante (22) et la partie contenant du métal (25).

2. Détecteur de lumière (100, 200, 300) selon la revendication 1, dans lequel
une position dans la première direction d'une partie de la partie contenant du métal (25) est identique à une position dans la première direction d'une interface entre la deuxième région semi-conductrice (2) et la troisième région semi-conductrice (3).

3. Détecteur de lumière (100, 200, 300) selon la revendication 2, comprenant en outre :
une couche conductrice (32),
l'élément (10) et le corps de structure (20) étant disposés sur la couche conductrice (32),
le corps de structure (20) étant séparé de la couche conductrice (32).

4. Détecteur de lumière (100, 200, 300) selon la revendication 2, comprenant en outre :
une couche conductrice (32),
l'élément (10) et le corps de structure (20) étant disposés sur la couche conductrice (32),
le corps de structure (20) étant en contact avec la couche conductrice (32).

5. Détecteur de lumière (100, 200, 300) selon l'une quelconque des revendications 1 à 4, comprenant en outre :
une interconnexion (41) disposée au-dessus de la troisième région semi-conductrice (3) et reliée électriquement à la troisième région semi-conductrice (3) ; et
une partie d'extinction (42) reliée électriquement entre la troisième région semi-conductrice (3) et l'interconnexion (41).

6. Détecteur de lumière (100, 200, 300) selon la revendication 5, dans lequel
une extrémité supérieure de la partie contenant du métal (25) est positionnée au-dessus de la troisième région semi-conductrice (3) et positionnée plus bas que l'interconnexion (41).

7. Détecteur de lumière (100, 200, 300) selon l'une quelconque des revendications 1 à 6, dans lequel
un vide est prévu dans la première partie isolante (21).

8. Détecteur de lumière (100, 200, 300) selon l'une quelconque des revendications 1 à 7, dans lequel
la deuxième région semi-conductrice (2) et la troisième région semi-conductrice (3) sont en contact avec le corps de structure (20).

9. Détecteur de lumière (100, 200, 300) selon l'une quelconque des revendications 1 à 7, dans lequel
une partie de la troisième région semi-conductrice (3) est en contact avec la première région semi-conductrice (1) dans la première direction.

10. Détecteur de lumière (100, 200, 300) selon l'une quelconque des revendications 1 à 9, dans lequel
la première partie isolante (21) et la deuxième partie isolante (22) comprennent du silicium et un élément choisi parmi le groupe constitué de l'oxygène et de l'azote.

11. Détecteur de lumière (100, 200, 300) selon l'une quelconque des revendications 1 à 10, dans lequel
la partie contenant du métal (25) comprend au moins un élément choisi parmi le groupe constitué du tungstène, de l'aluminium et du cuivre.

12. Détecteur de lumière (100, 200, 300), selon l'une quelconque des revendications 1 à 11, dans lequel
un indice de réfraction d'un matériau inclus dans les première et deuxième parties isolantes est inférieur à un indice de réfraction du matériau semi-conducteur présent dans l'élément (10), et
la partie contenant du métal (25) est configurée pour limiter une pénétration de photons secondaires provenant de l'élément (10) vers des éléments adjacents (10) davantage que les première et deuxième parties isolantes, les photons secondaires étant des photons générés à l'interface entre la deuxième région semi-conductrice et la troisième région semi-conductrice, lorsque de la lumière pénètre dans les éléments.

13. Détecteur de lumière (300), selon l'une quelconque des revendications 1 à 12, dans lequel le corps de structure (20) comprend
une partie inférieure comprenant la première partie isolante (21), et
une partie supérieure comprenant la deuxième partie isolante (22) et la partie contenant du métal (25), une largeur de la partie inférieure étant inférieure à une largeur de la partie supérieure, un vide (V) étant prévu dans la partie inférieure.

14. Détecteur de lumière (100, 200, 300) selon l'une quelconque des revendications 1 à 13, dans lequel
l'élément (10) comprend une photodiode à avalanche fonctionnant en mode Geiger.

15. Système de détection de lumière (R), comprenant :
le détecteur de lumière (410) selon l'une quelconque des revendications 1 à 14 ; et
un circuit de mesure de distance (408) calculant un temps de vol d'une lumière à partir d'un signal de sortie du détecteur de lumière (410).

16. Dispositif lidar (5001), comprenant :
une source lumineuse (404) émettant de la lumière vers un objet (411) ; et
le système de détection de lumière (R) selon la revendication 15, détectant de la lumière réfléchie par l'objet (411).

17. Dispositif lidar (5001) selon la revendication 16, comprenant en outre :
un système de reconnaissance d'image (407) générant une image tridimensionnelle sur la base d'une relation de disposition entre la source lumineuse (404) et le détecteur de lumière (411).

18. Véhicule (700), comprenant :
le dispositif lidar (5001) selon la revendication 16 ou 17.

19. Véhicule (700), comprenant :
une carrosserie (710) ; et
le dispositif lidar (5001) selon la revendication 16 ou 17 à chacun des quatre coins de la carrosserie (710).
